# EUROPEAN PATENT APPLICATION

(11) **EP 4 213 198 A1**
(43) Date of publication of application: **19.07.2023**
(21) Application number: 20955824.6
(22) Date of filing: 30.09.2020
(51) Int. Cl.: H01L 23/31, H01L 21/76

(54) **THREE-DIMENSIONAL INTEGRATED CIRCUIT AND METHOD FOR FABRICATION THEREOF AND ELECTRONIC DEVICE**

(71) Applicant: Huawei Technologies Co., Ltd., Shenzhen, Guangdong 518129 (CN)
(72) Inventor: HE, Ran, Shenzhen, Guangdong 518129 (CN); JIAO, Huifang, Shenzhen, Guangdong 518129 (CN); XU, Jeffrey Junhao, Shenzhen, Guangdong 518129 (CN)
(74) Representative: Körber, Martin Hans
(86) International application number: PCT/CN2020/119729
(87) International publication number: WO 2022/067804

(57) **Abstract**

A three-dimensional integrated circuit and a fabrication method thereof, and an electronic device are provided. The three-dimensional integrated circuit includes: a first chip, at least one second chip, a first substrate, a first wiring layer, and at least one first conductor. The first chip is bonded to a first surface of the first substrate. A first cavity is formed on the first substrate, and the second chip is accommodated in the first cavity and bonded with the first chip. The first wiring layer is formed on a second surface of the first substrate, where the first surface and the second surface of the first substrate are opposite. A first through hole that penetrates through the first surface and the second surface of the first substrate is further formed on the first substrate, and the first conductor is disposed in the first through hole. The first wiring layer and the first chip are coupled by using the first conductor.

## Description

### TECHNICAL FIELD

This disclosure relates to the field of semiconductor technologies, and in particular, to a three-dimensional integrated circuit and a fabrication method thereof, and an electronic device.

### BACKGROUND

With development of semiconductor technologies, requirements for integration density of integrated circuits are increasing. A three-dimensional integrated circuit (Three Dimensional Integrated Circuit, 3D IC for short) technology is used to fabricate three-dimensional integrated circuits, which can effectively implement small sizes and high density of the integrated circuits.

Currently, three-dimensional stacking of chips with different functions, different fabrication processes, and different sizes to implement integration of the chips is a mainstream development trend of the three-dimensional integrated circuits. After the chips with different sizes are stacked in a wafer-chip stacking manner, a small-sized chip is usually located at the top of a large-sized chip. A dielectric material needs to be deposited on a surface that is of the large-sized chip and that is not covered by the small-sized chip, and a through hole is formed in the dielectric material, to implement an interconnection between the large-sized chip and an external component by using a conductor formed in the through hole. A deposition process of the dielectric material needs to take long time, and it is difficult to machine a through hole with a small diameter and a large depth in the thick dielectric material. Therefore, a small size and high density of the three-dimensional integrated circuit are easily limited when the three-dimensional integrated circuit is fabricated in the wafer-chip stacking manner.

### SUMMARY

Embodiments of this disclosure provide a three-dimensional integrated circuit and a fabrication method thereof, and an electronic device, to simplify a fabrication process of the three-dimensional integrated circuit, so as to reduce production costs of the three-dimensional integrated circuit.

In one aspect, some embodiments of this disclosure provide a three-dimensional integrated circuit. The three-dimensional integrated circuit includes: a first chip, at least one second chip, a first substrate, a first wiring layer, and at least one first conductor. The first chip is bonded to a first surface of the first substrate. A first cavity is formed on the first substrate. The second chip is accommodated in the first cavity and bonded with the first chip. The first wiring layer is formed on a second surface of the first substrate, where the first surface and the second surface of the first substrate are opposite. A first through hole that penetrates through the first surface and the second surface of the first substrate is further formed on the first substrate. The first conductor is disposed in the first through hole. The first wiring layer and the first chip are coupled by using the first conductor.

In this embodiment of this disclosure, after the second chip with a smaller size is bonded to the first chip with a larger size, a periphery of the second chip may be supported by the first substrate that is bonded to the first chip and has the first cavity, to ensure a flat surface of the three-dimensional integrated circuit. Because the first substrate has a plate structure, the first substrate has specific structural strength. Therefore, forming the first through hole on the first substrate by using an etching process not only facilitates fabrication, but also facilitates formation of the first through hole with a small diameter and a large depth, thereby increasing distribution density of the first through hole. The first through hole penetrates through the first surface and the second surface of the first substrate. In this case, the first conductor is formed in the first through hole, and interconnection between the first chip and an external component, for example, coupling between the first chip and a metal pattern in the first wiring layer, can be implemented by using the first conductor.

In addition, in the fabrication process of the three-dimensional integrated circuit, the first chip is usually fabricated on a first wafer, and a process for bonding the first substrate with the first chip may be performed by using a wafer-level process. Therefore, a process flow of the three-dimensional integrated circuit is simplified, and production efficiency of the three-dimensional integrated circuit is improved.

Therefore, in this embodiment of this disclosure, a fabrication process of the three-dimensional integrated circuit can be simplified based on a small size and high density, to improve production efficiency and reduce production costs.

In some embodiments, the first substrate is a silicon substrate, and has a high thermal conductivity, which can further effectively improve heat dissipation performance of the three-dimensional integrated circuit. The three-dimensional integrated circuit further includes: an insulating dielectric filled between the second chip and an inner side wall of the first cavity, and an insulating film formed on an inner side wall of the first through hole. The silicon substrate and the second chip can be well insulated by using the insulating dielectric, and the silicon substrate and the first conductor can be well insulated by using the insulating film, thereby avoiding occurrence of charge accumulation or leakage current in the silicon substrate, and helping improve use reliability of the three-dimensional integrated circuit.

Further, the three-dimensional integrated circuit further includes: an insulation layer disposed between the first wiring layer and the silicon substrate and between the first wiring layer and the second chip. The insulation layer can well insulate the first wiring layer and the silicon substrate and insulate the first wiring layer and the second chip, thereby further improving the use reliability of the three-dimensional integrated circuit.

In some embodiments, the three-dimensional integrated circuit further includes at least one passive component. The at least one passive component includes at least one of a resistor, a capacitor, and an inductor. The passive component may be coupled to the metal pattern in the first wiring layer to form a functional circuit.

Optionally, the passive component is formed in a trench on a surface, away from the first chip, of the first substrate, and is coupled to the metal pattern in the first wiring layer. Therefore, the three-dimensional integrated circuit is light and thin.

Optionally, the passive component is formed in the first wiring layer, and is coupled to the metal pattern in the first wiring layer. Therefore, the fabrication process of the three-dimensional integrated circuit is simplified.

In some embodiments, the first chip includes a second wiring layer. The second chip includes a third wiring layer. The third wiring layer is bonded to the second wiring layer. The bonding between the second wiring layer and the third wiring layer may be direct bonding by dielectric layers, direct bonding by bonding pads, or hybrid bonding. An end, coupled to the first chip, of the first conductor is coupled to a metal pattern in the second wiring layer.

In some embodiments, the second chip includes at least one second through hole. The three-dimensional integrated circuit further includes at least one second conductor. The second conductor is disposed in the second through hole. One end of the second conductor is coupled to a metal pattern in the third wiring layer, and the other end of the second conductor is coupled to a metal pattern in the first wiring layer. The second conductor can implement signal transmission between the first wiring layer and the third wiring layer

In some embodiments, according to a size relationship between the second chip and the first chip, a third chip having another function or size may be further bonded to the first chip. For example, the three-dimensional integrated circuit further includes at least one third chip. The third chip is bonded to the first chip and located on a same side of the first chip as the second chip.

Optionally, a second cavity is further formed on the first substrate. The third chip is accommodated in the second cavity. The first wiring layer is further located on a side, away from the first chip, of the third chip. The first cavity matched with the second chip and the second cavity matched with the third chip are separately formed on the first substrate, which helps improve precision of bonding between the first substrate and the first chip.

Further, the first substrate is a silicon substrate. The three-dimensional integrated circuit further includes: an insulating dielectric filled between the third chip and an inner side wall of the second cavity, and an insulation layer disposed between the first wiring layer and the silicon substrate, between the first wiring layer and the second chip, and between the first wiring layer and the third chip. Functions of the insulating dielectric and the insulation layer are as described in some of the foregoing embodiments.

Optionally, the third chip is accommodated in the first cavity. The third chip is insulated from the second chip accommodated in the same first cavity. The first wiring layer is further located on a side, away from the first chip, of the third chip. The third chip and the second chip are jointly accommodated in the first cavity of the first substrate, to reduce a spacing between the second chip and the third chip, thereby further implementing a small size and high density of the three-dimensional integrated circuit.

Further, the first substrate is a silicon substrate. The three-dimensional integrated circuit further includes: an insulating dielectric filled between any two of the second chip, the third chip, and the inner side wall of the first cavity, and an insulation layer disposed between the first wiring layer and the silicon substrate, between the first wiring layer and the second chip, and between the first wiring layer and the third chip. Functions of the insulating dielectric and the insulation layer are as described in some of the foregoing embodiments.

In some embodiments, the first chip includes a second wiring layer. The third chip includes a fourth wiring layer. The fourth wiring layer is bonded with the second wiring layer. The third chip includes at least one third through hole. The three-dimensional integrated circuit further includes at least one third conductor. The third conductor is disposed in the third through hole. One end of the third conductor is coupled to a metal pattern in the fourth wiring layer, and the other end of the third conductor is coupled to the metal pattern in the first wiring layer. The third conductor can implement signal transmission between the first wiring layer and the fourth wiring layer.

In some embodiments, the three-dimensional integrated circuit further includes at least one conductive micro-bump. The conductive micro-bump is disposed on a surface, away from the first chip, of the first wiring layer, and is coupled to the metal pattern in the first wiring layer. The conductive micro-bump facilitates coupling between the three-dimensional integrated circuit and an external component.

In some other embodiments, one or more layers of chips, for example, a fourth chip, may be further stacked on the surface, away from the first chip, of the first wiring layer along a thickness direction of the first chip. That is, the three-dimensional integrated circuit further includes at least one fourth chip. The fourth chip is bonded to the surface, away from the first chip, of the first wiring layer, and is coupled to the metal pattern in the first wiring layer.

Optionally, the fourth chip includes a fifth wiring layer. The fifth wiring layer is bonded with the first wiring layer. The fourth chip further includes at least one fourth through hole. The three-dimensional integrated circuit further includes at least one fourth conductor, and a sixth wiring layer disposed on a surface, away from the first wiring layer, of the fourth chip. The fourth conductor is disposed in the fourth through hole. One end of the fourth conductor is coupled to a metal pattern in the fifth wiring layer, and the other end of the fourth conductor is coupled to a metal pattern in the sixth wiring layer. The fourth conductor may implement signal transmission between the fourth chip and the sixth wiring layer.

Optionally, the three-dimensional integrated circuit further includes a second substrate, a sixth wiring layer, and at least one fifth conductor. A third cavity is formed on the second substrate, and the fourth chip is accommodated in the third cavity. A first surface of the second substrate is bonded to the surface, away from the first substrate, of the first wiring layer. The sixth wiring layer is formed on a second surface of the second substrate, where the first surface and the second surface of the second substrate are opposite. A fifth through hole that penetrates through the first surface and the second surface of the second substrate is further formed on the second substrate. The fifth conductor is disposed in the fifth through hole. One end of the fifth conductor is coupled to the metal pattern in the first wiring layer, and the other end of the fifth conductor is coupled to the metal pattern in the sixth wiring layer. The fifth conductor can implement signal transmission between the first wiring layer and the sixth wiring layer. Technical effects that can be achieved by the second substrate are the same as technical effects that can be achieved by the first substrate in some of the foregoing embodiments. Details are not described herein again.

Further, the three-dimensional integrated circuit further includes at least one conductive micro-bump. The conductive micro-bump is disposed on a surface, away from the fourth chip, of the sixth wiring layer, and is coupled to the metal pattern in the sixth wiring layer. The conductive micro-bump facilitates coupling between the three-dimensional integrated circuit and an external component.

In another aspect, some embodiments of this disclosure provide an electronic device. The electronic device includes: at least one three-dimensional integrated circuit in some of the foregoing embodiments, and an external component coupled to the three-dimensional integrated circuit. Herein, the external component includes at least one of an interposer and a packaging substrate. Technical effects that can be achieved by the electronic device in this embodiment of this disclosure are the same as technical effects that can be achieved by the three-dimensional integrated circuit in some of the foregoing embodiments. Details are not described herein again.

In still another aspect, some embodiments of this disclosure provide a fabrication method of a three-dimensional integrated circuit. The fabrication method includes: providing a plurality of second chips and a first wafer that is fabricated with a plurality of first chips, and bonding the second chips to the first wafer, so that at least one of the second chips is bonded to one of the first chips; aligning and bonding a first substrate to the first wafer bonded with the second chips, so that the second chip is accommodated in a first cavity on the first substrate and insulated from the first cavity; forming a plurality of first through holes on the first substrate; forming a first conductor in the first through hole, so that one end of the first conductor is coupled to the first chip, and the other end of the first conductor is exposed; forming a first wiring layer on a surface, away from the first wafer, of the first substrate, where a metal pattern in the first wiring layer is coupled to the other end of the first conductor; and scribing the first wafer and a structure thereon along scribe lines to obtain a plurality of three-dimensional integrated circuits. Technical effects that can be achieved by the fabrication method of a three-dimensional integrated circuit in this embodiment of this disclosure are the same as technical effects that can be achieved by the three-dimensional integrated circuit in some of the foregoing embodiments. Details are not described herein again.

Optionally, the aligning and bonding a first substrate to the first wafer bonded with the second chips further includes: providing a first original substrate, where the first cavity is formed on the first original substrate, and the first cavity does not penetrate through the first original substrate, a volume of the first cavity is greater than that of the second chip, and the first cavity can accommodate the second chip; aligning and bonding the first original substrate to the first wafer bonded with the second chips, so that the second chip is accommodated in the first cavity on the first original substrate, and there is a spacing between the second chip and the first cavity; and thinning the first original substrate from a side, away from the first wafer, of the first original substrate until the second chip is exposed, where the thinned first original substrate is the foregoing first substrate.

Further, a thinning process for the first original substrate includes at least one of a grinding process and an etching process. The etching process includes at least one of dry etching and wet etching.

For example, a grinding process is used for a part, farther from the second chip, of the first original substrate, and a dry etching process is used for a part, closer to the second chip, of the first original substrate. Because the first original substrate is thinned after bonded to the first wafer, thinning the first original substrate by using the foregoing process helps to slowly release stress generated by thinning the first original substrate, thereby avoiding damage to the first chip due to a large stress effect, and ensuring use reliability of the three-dimensional integrated circuit.

In some embodiments, before the plurality of first through holes are formed in the first substrate, the fabrication method of a three-dimensional integrated circuit further includes: depositing an insulating medium in the spacing between the second chip and the first cavity.

In some embodiments, the first substrate is a silicon substrate. The fabrication method of a three-dimensional integrated circuit further includes: before forming a plurality of first through holes on the first substrate, forming an insulation layer on surfaces, away from the first wafer, of the first substrate and the second chip; and after forming the plurality of first through holes on the first substrate, forming an insulating film on an inner side wall of the first through hole.

In some embodiments, before the first wiring layer is formed on the surface, away from the first wafer, of the first substrate, the fabrication method of a three-dimensional integrated circuit further includes: forming a plurality of trenches on a surface, away from the first chip, of the first substrate; and forming at least one passive component in the plurality of trenches, so that the metal pattern in the first wiring layer is further coupled to the passive component. The at least one passive component includes at least one of a resistor, a capacitor, and an inductor.

In some other embodiments, the forming a first wiring layer on the surface, away from the first wafer, of the first substrate further includes: forming at least one passive component between some layers in the first wiring layer, so that the passive component is coupled to the metal pattern in the first wiring layer. The at least one passive component includes at least one of a resistor, a capacitor, and an inductor.

Optionally, the fabrication method of a three-dimensional integrated circuit further includes: forming at least one second through hole on the at least one second chip; and forming a second conductor in the second through hole, so that one end of the second conductor is coupled to a third wiring layer in the second chip, and the other end of the second conductor is exposed. In this way, after the first wiring layer is subsequently formed, the metal pattern in the first wiring layer may be coupled to the other end of the second conductor.

In some embodiments, before the first substrate is aligned and bonded to the first wafer bonded with the second chips, the fabrication method of a three-dimensional integrated circuit further includes: providing a plurality of third chips, and bonding the third chips and the second chips to the first wafer at a same layer, so that at least one of the third chips is further bonded to one of the first chips.

The aligning and bonding a first substrate to the first wafer bonded with the second chips further includes: enabling the third chip to be accommodated in the first cavity or the second cavity on the first substrate.

In some embodiments, before the first wafer and the structure thereon are scribed along the scribe lines, the fabrication method of a three-dimensional integrated circuit further includes: providing a plurality of fourth chips, and bonding the fourth chips to a surface, away from the first chips, of the first wiring layer, so that the fourth chips are coupled to the metal pattern in the first wiring layer, and an orthographic projection of the fourth chip on the first wafer is located within an orthographic projection of the first chip on the first wafer

In some embodiments, before the first wafer and the structure thereon are scribed along the scribe lines, the fabrication method of a three-dimensional integrated circuit further includes: forming at least one fourth through hole on at least one of the fourth chips; forming a fourth conductor in the fourth through hole, so that one end of the fourth conductor is coupled to a fifth wiring layer in the fourth chip, and the other end of the fourth conductor is exposed; and forming a sixth wiring layer on a surface, away from the first wiring layer, of the fourth chip, so that a metal pattern in the sixth wiring layer is coupled to the other end of the fourth conductor.

In some other embodiments, before the first wafer and the structure thereon are scribed along the scribe lines, the fabrication method of a three-dimensional integrated circuit further includes: aligning and bonding a second substrate to the first wiring layer bonded with the fourth chips, so that the fourth chips are accommodated in a third cavity on the second substrate; forming a plurality of fifth through holes on the second substrate; forming a fifth conductor in the fifth through hole, so that one end of the fifth conductor is coupled to the metal pattern in the first wiring layer, and the other end of the fifth conductor is exposed; and forming a sixth wiring layer on the surface, away from the first wafer, of the second substrate, so that a metal pattern in the sixth wiring layer is coupled to the other end of the fifth conductor.

In some embodiments, before the first wafer and the structure thereon are scribed along the scribe lines, the fabrication method of a three-dimensional integrated circuit further includes: forming at least one conductive micro-bump on a surface, away from the fourth chip, of the sixth wiring layer, so that the conductive micro-bump is coupled to the metal pattern in the sixth wiring layer.

### BRIEF DESCRIPTION OF DRAWINGS

To describe technical solutions in some embodiments of this disclosure more clearly, the following briefly describes accompanying drawings used in describing the some embodiments. It is clear that the accompanying drawings in the following descriptions show only some embodiments of this disclosure, and a person of ordinary skill in the art may derive other drawings from these accompanying drawings.
FIG. 1 is a schematic diagram of a partial structure of an electronic device according to some embodiments of this disclosure;
FIG. 2 is a schematic diagram of a partial structure of another electronic device according to some embodiments of this disclosure;
FIG. 3A is a schematic diagram of a structure of a three-dimensional integrated circuit according to some embodiments of this disclosure;
FIG. 3B is a top view of a cross section of the three-dimensional integrated circuit shown in FIG. 3A along an AA' direction;
FIG. 3C is a top view of a first substrate in the three-dimensional integrated circuit shown in FIG. 3A;
FIG. 4A to FIG. 4C are flowcharts of a fabrication method of the three-dimensional integrated circuit shown in FIG. 3A;
FIG. 5A is a schematic diagram of a structure of another three-dimensional integrated circuit according to some embodiments of this disclosure;
FIG. 5B is a top view of a cross section of the three-dimensional integrated circuit shown in FIG. 5A along an AA' direction;
FIG. 6 is a partial flowchart of a partial fabrication method of the three-dimensional integrated circuit shown in FIG. 5A;
FIG. 7A is a schematic diagram of a structure of still another three-dimensional integrated circuit according to some embodiments of this disclosure;
FIG. 7B is a schematic top view of a first substrate on which a passive component is disposed in FIG. 7A;
FIG. 8 is a schematic diagram of a structure of still another three-dimensional integrated circuit according to some embodiments of this disclosure;
FIG. 9A is a schematic diagram of a structure of still another three-dimensional integrated circuit according to some embodiments of this disclosure;
FIG. 9B is a top view of a cross section of the three-dimensional integrated circuit shown in FIG. 9A along an AA' direction;
FIG. 9C is a top view of a first substrate in the three-dimensional integrated circuit shown in FIG. 9A;
FIG. 10A is a schematic diagram of a structure of still another three-dimensional integrated circuit according to some embodiments of this disclosure;
FIG. 10B is a top view of a cross section of the three-dimensional integrated circuit shown in FIG. 10A along an AA' direction;
FIG. 10C is a top view of a first substrate in the three-dimensional integrated circuit shown in FIG. 10A;
FIG. 11A is a schematic diagram of a structure of still another three-dimensional integrated circuit according to some embodiments of this disclosure;
FIG. 11B is a top view of a cross section of the three-dimensional integrated circuit shown in FIG. 11A along an AA' direction;
FIG. 12 is a schematic diagram of a structure of still another three-dimensional integrated circuit according to some embodiments of this disclosure;
FIG. 13A is a schematic diagram of a structure of still another three-dimensional integrated circuit according to some embodiments of this disclosure; and
FIG. 13B is a top view of a second substrate in the three-dimensional integrated circuit shown in FIG. 13A.

Reference numerals:
1000: electronic device; 100: external component; 110: packaging substrate;
120: interposer; 121: silicon substrate; 122 and 123: two wiring layers in the interposer;
124: conductor in the interposer; 130: ball grid array; 300: PCB;
200: three-dimensional integrated circuit; 1: first chip; 11: first wafer;
10: second wiring layer; 101: dielectric layer in the second wiring layer;
102: signal line in the second wiring layer; 103: bonding pad in the second wiring layer;
2: second chip; 20: third wiring layer;
201: dielectric layer in the third wiring layer; 202: signal line in the third wiring layer;
203: bonding pad in the third wiring layer; 3: first substrate;
3': first original substrate; 030: passive component;
031: capacitor; 032: inductor; 033: resistor;
30: first wiring layer; 301: dielectric layer in the first wiring layer;
302: metal pattern in the first wiring layer; 31: insulating dielectric;
40: fourth wiring layer; 41: first conductor; 42: second conductor;
43: third conductor; 44: fourth conductor; 45: fifth conductor;
5: insulation layer; 6: conductive micro-bump; 7: third chip;
8: fourth chip; 9: second substrate;
50: fifth wiring layer; and 60: sixth wiring layer.

### DESCRIPTION OF EMBODIMENTS

The following clearly and completely describes the technical solutions in some embodiments of this disclosure with reference to the accompanying drawings in some embodiments of this disclosure. It is clear that the described embodiments are merely some but not all of embodiments of this disclosure. All other embodiments obtained by a person of ordinary skill in the art based on some embodiments of this disclosure shall fall within the protection scope of this disclosure.

Unless otherwise required by the context, throughout this specification and claims, the term "comprise (comprise)" and its other forms such as a third person singular form "comprises (comprises)" and a present participle form "comprising (comprising)" are interpreted as "open and inclusive", that is, "comprise, but is not limited to". In the description of this specification, the terms such as "one embodiment (one embodiment)", "some embodiments (some embodiments)", "exemplary embodiments (exemplary embodiments)", "an example (example)", "a specific example (specific example)", or "some examples (some examples)" are intended to indicate that specific features, structures, materials, or characteristics related to the embodiment or example are included in at least one embodiment or example of this disclosure. The foregoing example expressions of the terms are not necessarily with respect to a same embodiment or example. In addition, these specific features, structures, materials, or characteristics may be included in any one or more embodiments or examples in any appropriate manner.

The following orientation terms such as " above", "below", "left", and "right" may be defined by, but are not limited to, orientations of components schematically placed in the accompanying drawings. It should be understood that these orientation terms may be relative concepts, are used for description and clarification of "relative to", and may vary accordingly based on a change in the positions in which the components in the accompanying drawings are placed.

The terms "first", "second", and the like are merely intended for a purpose of description, and shall not be understood as an indication or implication of relative importance or implicit indication of a quantity of indicated technical features. Therefore, a feature limited by "first", "second", and the like may explicitly or implicitly include one or more features. In the descriptions of embodiments of this disclosure, unless otherwise specified, " a plurality of" means two or more.

When some embodiments are described, expressions of "coupled" and "connected" and their extensions may be used. For example, when some embodiments are described, the term "connected" may be used to indicate that two or more components are in direct physical contact or electrical contact with each other. For another example, when some embodiments are described, the term "coupled" may be used to indicate that two or more components are in direct physical contact or electrical contact. However, the term "coupled" or "communicatively coupled (communicatively coupled)" may alternatively indicate that two or more components are not in direct contact with each other, but still cooperate or interact with each other Embodiments disclosed herein are not necessarily limited to the content of this specification.

"At least one of A, B, and C" has the same meaning as "at least one of A, B, or C", and includes the following combinations of A, B, and C: only A, only B, only C, a combination of A and B, a combination of A and C, a combination of B and C, and a combination of A, B, and C.

"A and/or B" includes the following three combinations: only A, only B, and a combination of A and B.

The use of" applicable to" or "configured to" in this specification means an open and inclusive language, which does not exclude a device applicable to or configured to perform an additional task or step. In addition, the use of "based on" means openness and inclusiveness, because a process, a step, calculation, or another action "based on" one or more conditions or values may be, in practice, based on additional conditions or beyond the values described.

Moreover, to clearly represent a plurality of layers and regions in the accompanying drawings, thicknesses of the layers in the drawings are enlarged to clearly illustrate relative positions between the layers. When a part expressed as a layer, a film, a region, a plate, or the like is located "above" or "on" another part, this not only includes a case in which the part is "directly" located above the another part, but also includes a case in which still another layer exists between the part and the another part.

Some embodiments of this disclosure provide an electronic device. The electronic device includes an electronic product, for example, a mobile phone (mobile phone), a pad (pad), a computer, a smart wearable product (for example, a smart watch or a smart band), a media player, a portable electronic device, a virtual reality (Virtual Reality, VR for short) terminal device, or an augmented reality (Augmented Reality, AR for short) terminal device. A specific form of the foregoing electronic device is not particularly limited in embodiments of this disclosure.

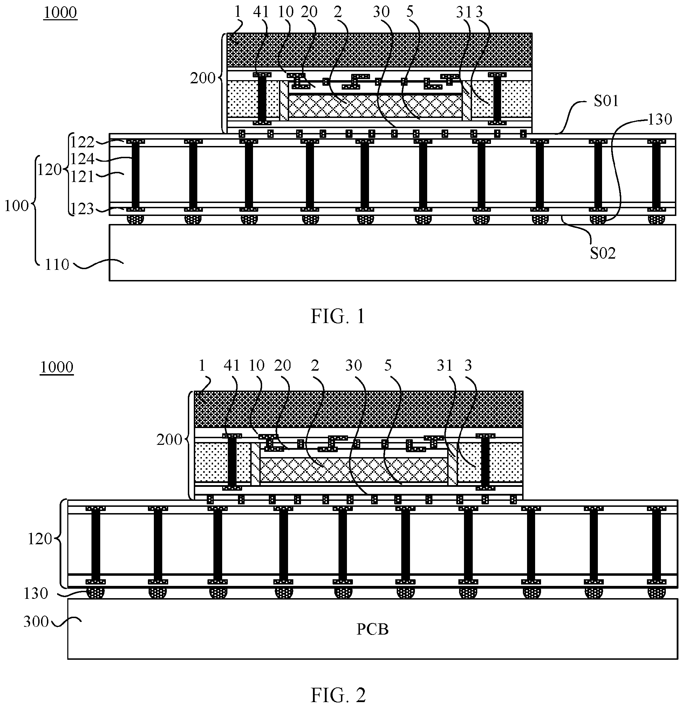

For example, refer to FIG. 1. The foregoing electronic device 1000 includes an external component 100 and at least one three-dimensional integrated circuit 200 coupled to the external component 100. The external component 100 includes at least one of a packaging substrate 110 or an interposer (Silicon Interposer) 120. The interposer 120 may be an active interposer or a passive interposer.

Optionally, as shown in FIG. 1, the interposer 120 is a silicon interposer. The interposer 120 includes a silicon substrate 121, and wiring layers 122 and 123 disposed on two opposite surfaces of the silicon substrate 121 respectively. A plurality of silicon through holes are disposed on the silicon substrate 121. A conductor 124 is disposed in the silicon through hole, and the two wiring layers 122 and 123 in the interposer 120 are interconnected by the conductor 124 in each silicon through hole. The interposer 120 may implement transmission of electrical signals between electrical components coupled to two sides of the interposer 120. On this basis, the three-dimensional integrated circuit 200 and the packaging substrate 110 may be interconnected by the interposer 120. For example, the three-dimensional integrated circuit 200 is bonded to a first surface S01 of the interposer 120, and the packaging substrate 110 is bonded to a second surface S02 of the interposer 120.

Optionally, the three-dimensional integrated circuit 200 and the wiring layer 122 in the interposer 120 are correspondingly coupled by a bonding pad or a pad formed on a surface of the three-dimensional integrated circuit 200. A plurality of conductive micro-bumps (Micro-Bump) are formed on a surface of the wiring layer 123 in the interposer 120, and the interposer 120 and the packaging substrate 110 are correspondingly coupled by the conductive micro-bumps (Micro-Bump). The conductive micro-bump is, for example, a solder ball or a copper pillar bump (Copper Pillar Bump) in a bonding pad, a pad, or a ball grid array (Ball Grid Array, BGA for short). Optionally, as shown in FIG. 1, the interposer 120 and the packaging substrate 110 are coupled by a ball grid array 130.

The foregoing three-dimensional integrated circuit 200 may include a plurality of chips stacked in three-dimensional space. Herein, each chip may be a logic chip or a storage chip.

In some embodiments, as shown in FIG. 2, the electronic device 1000 further includes a printed circuit board (Printed Circuit Board, PCB for short) 300. The foregoing external component 100 and the PCB 300 may also be coupled by an electrical connector. The electrical connector is, for example, a connector having good conductivity, such as a ball grid array 130 or a plurality of copper pillar bumps arranged in an array.

Optionally, as shown in FIG. 2, the external component 100 is an interposer 120. The three-dimensional integrated circuit 200 is bonded to the interposer 120. The interposer 120 and the PCB 300 are coupled by the ball grid array 130. In this case, the foregoing three-dimensional integrated circuit 200 may implement signal transmission with another chip or a chip stacking structure on the PCB 300 by using the interposer 120.

The following describes a structure of the foregoing three-dimensional integrated circuit 200.

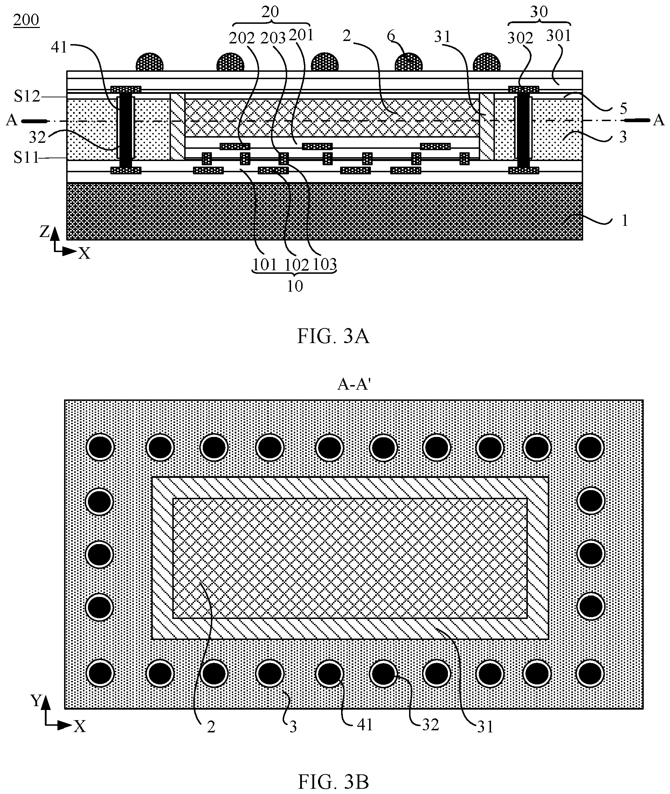

In some embodiments of this disclosure, with reference to FIG. 3A and FIG. 3B, the three-dimensional integrated circuit 200 includes a first chip 1, at least one second chip 2, a first substrate 3, and a first wiring layer 30.

Herein, the first chip 1 may be directly fabricated on a first wafer The second chip 2 and the first chip 1 have different sizes. For example, the second chip 2 is smaller than or farther smaller than the first chip 1. In this case, one or more second chips 2 may be bonded to the first chip 1. A quantity of second chips 2 is not limited in this embodiment of this disclosure. FIG. 3A shows only one second chip 2.

The second chip 2 and the first substrate 3 are bonded to a same side of the first chip 1 respectively. The first substrate 3 is a substrate that can be bonded with the first wafer where the first chip 1 is located, for example, is a silicon substrate or a glass substrate. The first substrate 3 and the first chip 1 may be bonded by a wafer-level bonding process.

In some embodiments, with reference to FIG. 3A to FIG. 3C, the first chip 1 is bonded to a first surface S11 of the first substrate 3. The first wiring layer 30 is formed on a second surface S12 of the first substrate 3, that is, on a surface, away from the first chip 1, of the first substrate 3. A first cavity Q1 is formed on the first substrate 3, and the first cavity Q1 can be used for accommodating the second chip 2. The first cavity Q 1 and the second chip 2 may be disposed in a one-to-one correspondence. A size of the first cavity Q1 is generally greater than or slightly greater than that of the corresponding second chip 2, and the size includes a length along an X direction, a width along a Y direction, and a depth or a thickness along a Z direction. Accordingly, an orthographic projection area S1 of the first cavity Q1 on the first chip 1 is greater than an orthographic projection area S2 of the corresponding second chip 2 on the first chip 1. Each second chip 2 may be located in the corresponding first cavity Q1, and there is a spacing between each second chip 2 and the corresponding first cavity Q1. This facilitates aligning and bonding of the first substrate 3 with the first chip 1. Herein, the second chip 2 is insulated from an inner side wall of the corresponding first cavity Q1. In addition, optionally, a shape of the first cavity Q1 is the same as or similar to that of the second chip 2. When there are a plurality of second chips 2 and the second chips 2 are in a one-to-one correspondence with first cavities Q1, distribution positions of the plurality of first cavities Q1 can be rationally designed on the first substrate 3 based on the shape of the second chips 2, to improve space utilization of the first substrate 3.

In a finished product of the three-dimensional integrated circuit 200, as shown in FIG. 3A, the first cavity Q1 penetrates through the first surface S11 and the second surface S12 of the first substrate 3 along a thickness direction of the first substrate 3. A thickness of the first substrate 3 is equal to or approximately equal to that of the second chip 2. In other words, the first substrate 3 does not cover the second chip 2, and surfaces, away from the first chip 1, of the two are flush or approximately flush.

Optionally, the first substrate 3 is a finished product preset with a plurality of first cavities Q1. In this case, it is also allowed that the thickness of the first substrate 3 is less than or greater than the thickness of the second chip 2, that is, the second chip 2 is exposed relative to the first substrate 3.

Optionally, the first substrate 3 is obtained by thinning a first original substrate on which a plurality of first cavities Q1 are disposed. The first original substrate differs from the first substrate 3 only in their thicknesses. For example, the first cavity Q1 does not penetrate through the first original substrate. This facilitates a bonding operation between the first original substrate and the first wafer where the first chip 1 is located. Specifically, the first original substrate is provided. A plurality of first cavities Q1 are formed on the first original substrate by using a dry etching process or a wet etching process, where the depth of the first cavity Q1 is less than the thickness of the first original substrate. Then, the first original substrate is aligned and bonded to the first wafer where the first chip 1 is located, so that the second chip 2 is accommodated in the corresponding first cavity Q1. Thereafter, the first original substrate is thinned from a side, away from the first chip 1, of the first original substrate until the second chip 2 is exposed, and the foregoing first substrate 3 can be obtained.

In some embodiments, the first substrate 3 is a silicon substrate. An insulating dielectric 31 is filled between the second chip 2 and the inner side wall of the corresponding first cavity Q1. The insulating dielectric 31 may be either an inorganic insulating material or an organic insulating material. The inorganic insulating material is, for example, silicon oxide, silicon nitride, or silicon nitride. The organic insulating material is, for example, epoxy resin. The insulating dielectric 31 may be deposited between the second chip 2 and the inner side wall of the corresponding first cavity Q1 by using a process such as plasma enhanced chemical vapor deposition (Plasma Enhanced Chemical Vapor Deposition, PECVD for short) or atomic layer deposition (Atomic Layer Deposition, ALD for short). In this embodiment of this disclosure, the insulating dielectric 31 may well insulate the silicon substrate from the second chip 2, which can avoid occurrence of charge accumulation or leakage current in the silicon substrate, and help improve use reliability of the three-dimensional integrated circuit 200.

Continue to refer to FIG. 3A to FIG. 3C. The first wiring layer 30 includes: a dielectric layer 301 and a metal pattern 302 formed in the dielectric layer 301. The dielectric layer 301 may be formed by a plurality of different layers of insulating films, and the metal pattern 302 may be disposed on one layer of insulating film, or may be disposed on plurality of layers of insulating films. Generally, the metal pattern 302 is a multi-layer pattern disposed on the plurality of layers of insulating films, where patterns of some layers are sandwiched between two layers of insulating films of the dielectric layer 301, and patterns of some layers are exposed to a surface of the dielectric layer 301 and may be used for coupling with an external electrical element. For example, a pattern in the metal pattern 302 that is located between two layers of insulating films exists in a manner of a signal line, and a pattern in the metal pattern 302 that is exposed to the surface of the dielectric layer 301 exists in a manner of a bonding pad or a pad.

In some embodiments, the metal pattern 302 in the first wiring layer 30 includes a part exposed to a surface, close to the first chip 1, of the dielectric layer 301. The three-dimensional integrated circuit 200 further includes: an insulation layer 5 disposed between the first wiring layer 30 and the first substrate 3 and between the first wiring layer 30 and the second chip 2. When the first substrate 3 is a silicon substrate, the insulation layer 5 can achieve an insulation effect, to prevent an electrical signal in the first wiring layer 30 from being transferred to a silicon material of the silicon substrate, to improve use reliability of the three-dimensional integrated circuit 200. The insulation layer 5 may be made of an inorganic insulating material or an organic insulating material. The inorganic insulating material is, for example, silicon oxide, silicon nitride, or silicon nitride. The organic insulating material is, for example, epoxy resin. The insulation layer 5 may be deposited by using a process such as plasma enhanced chemical vapor deposition (Plasma Enhanced Chemical Vapor Deposition, PECVD for short) or atomic layer deposition (Atomic Layer Deposition, ALD for short).

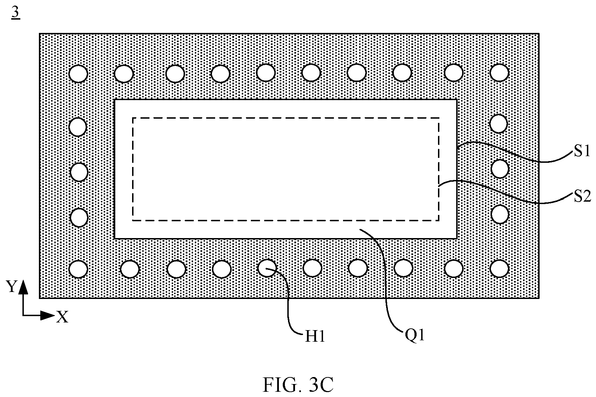

As shown in FIG. 3C, at least one first through hole H1 that penetrates through the first surface S11 and the second surface S12 of the first substrate 3 is further formed on the first substrate 3. The three-dimensional integrated circuit 200 further includes at least one first conductor 41. The first conductor 41 is disposed in the first through hole H1. One end of the first conductor 41 is coupled to the first chip 1; and the other end of the first conductor 41 is coupled to the metal pattern 302 in the first wiring layer 30. Herein, the first conductor 41 refers to a conductive columnar metal object that is made of a metal material filled in the first through hole H1. The first conductor 41 can be used for implementing transmission of an electrical signal between the first chip 1 and the first wiring layer 30.

In this embodiment of this disclosure, after the second chip 2 with a smaller size is bonded to the first chip 1 with a larger size, a periphery of the second chip 2 may be supported by the first substrate 3 that is bonded to the first chip 1 and has the first cavity Q1, to ensure a flat surface of the three-dimensional integrated circuit 200. Because the first substrate 3 has a plate structure, the first substrate 3 has specific structural strength. Therefore, forming the first through hole H1 in the first substrate 3 by using an etching process not only facilitates fabrication, but also facilitates formation of the first through hole H1 with a small diameter and a large depth, thereby increasing distribution density of the first through hole H1. The first through hole H1 penetrates through the first surface S11 and the second surface S12 of the first substrate 3. In this way, the first conductor 41 is formed in the first through hole H1, and interconnection between the first chip 1 and an external component, for example, coupling between the first chip 1 and the metal pattern 302 in the first wiring layer 30, may be implemented by using the first conductor 41.

In addition, in the fabrication process of the three-dimensional integrated circuit 200, the first chip 1 is usually fabricated on a first wafer, and a process for bonding the first substrate 3 with the first chip 1 may be performed by using a wafer-level process. Therefore, a process flow of the three-dimensional integrated circuit 200 is simplified, and production efficiency of the three-dimensional integrated circuit 200 is improved.

In this embodiment of this disclosure, a fabrication process of the three-dimensional integrated circuit 200 can be simplified based on a small size and high density of the three-dimensional integrated circuit, to improve production efficiency and reduce production costs.

In addition, when the first substrate 3 is a silicon substrate, the first substrate 3 has a high thermal conductivity, which can further effectively improve heat dissipation performance of the three-dimensional integrated circuit 200.

Optionally, when there are a plurality of first through holes H1, the plurality of first through holes H1 are evenly distributed, for example, evenly distributed on a periphery of the corresponding first cavity Q1, to facilitate a hole forming process, to ensure process consistency of the plurality of first through holes H1.

It should be added that, when the first substrate 3 is a silicon substrate, as shown in FIG. 3A and FIG. 3B, an insulating film 32 may be disposed on an inner side wall of each first through hole H1. The first conductor 41 is insulated from the silicon substrate by using the insulating film 32, which can avoid occurrence of charge accumulation or leakage current in the silicon substrate, and improve use reliability of the three-dimensional integrated circuit 200.

It may be understood that any chip generally includes a substrate and a circuit structure disposed on the substrate. The substrate is, for example, a glass substrate or a silicon substrate. The silicon substrate is, for example, an amorphous silicon (Amorphous Silicon, a-Si for short) substrate or a silicon carbide (SiC) substrate. A circuit structure may be configured according to an actual requirement. For example, the circuit structure is formed by connecting a plurality of electronic components such as a field-effect transistor (MOS), a thin film transistor (TFT), a capacitor, and a resistor. A plurality of input/output (I/O) ends of the circuit structure may be implemented by a wiring layer.

In some embodiments, as shown in FIG. 3A, the first chip 1 includes a second wiring layer 10, and the second chip 2 includes a third wiring layer 20. Bonding between the second chip 2 and the first chip 1 is represented as bonding between the third wiring layer 20 in the second chip 2 and the second wiring layer 10 in the first chip 1.

Herein, structures of the second wiring layer 10 and the third wiring layer 20 are similar to a structure of the first wiring layer 30, and each structure includes a dielectric layer and a metal pattern. The difference between the three wiring layers is graphic design of the metal patterns. The bonding between the second wiring layer 10 and the third wiring layer 20 refers to an electrical connection between the metal pattern in the second wiring layer 10 and the metal pattern in the third wiring layer 20.

The metal pattern in the second wiring layer 10 may be designed according to the circuit structure in the first chip 1, and the metal pattern includes, for example, a signal line 102 disposed between two layers of insulating film, and a bonding pad 103 exposed to a surface, close to the third wiring layer 20, of the dielectric layer 101. The metal pattern in the third wiring layer 20 may be designed according to the circuit structure in the second chip 2, and the metal pattern includes, for example, a signal line 202 disposed between two layers of insulating film, and a bonding pad 203 exposed to a surface, close to the second wiring layer 10, of the dielectric layer 201. A bonding manner between the second wiring layer 10 and the third wiring layer 20 may be any one of direct bonding by dielectric layers, direct bonding by bonding pads, or hybrid bonding, as long as the electrical connection of the metal patterns in the second wiring layer 10 and the third wiring layer 30 can be implemented. In a case of direct bonding by a bonding pad, the bonding pad may protrude from the dielectric layer in the corresponding wiring layer.

In some of the foregoing embodiments, coupling of one end of the first conductor 41 to the first chip 1 is represented as coupling of one end of the first conductor 41 to the metal pattern in the second wiring layer 10, for example, coupling to the bonding pad 103.

In all the accompanying drawings involved in embodiments of this disclosure, only existence of the dielectric layer and the metal pattern in each wiring layer is illustrated, but graphic design of the metal pattern, a position of the metal pattern in the dielectric layer, and coupling of the metal pattern to an external electrical element are not limited. That is, the metal pattern in each wiring layer may be designed according to an actual requirement, to implement an electrical connection of corresponding components on two sides of the wiring layer. This is not limited in this embodiment of this disclosure. Moreover, in this embodiment of this disclosure, the second wiring layer 10 is a component of the first chip 1, and the third wiring layer 20 is a component of the second chip 2. The second wiring layer 10 and the third wiring layer 20 are independent of corresponding chip marks, mainly to highlight corresponding electrical connection structures.

In some embodiments, as shown in FIG. 3A, the three-dimensional integrated circuit 200 further includes at least one conductive micro-bump 6. The conductive micro-bump 6 is, for example, a solder ball or a copper pillar bump in a bonding pad, a pad, or a ball grid array. A quantity of conductive micro-bumps 6 may be configured according to an actual requirement. For example, there are a plurality of conductive micro-bumps 6, and the plurality of conductive micro-bumps 6 are distributed in an array on the surface, away from the first chip 1, of the first wiring layer 30, and are coupled to the metal pattern in the first wiring layer 30. Each conductive micro-bump 6 may be configured to implement coupling between the three-dimensional integrated circuit 200 and the external component 100.

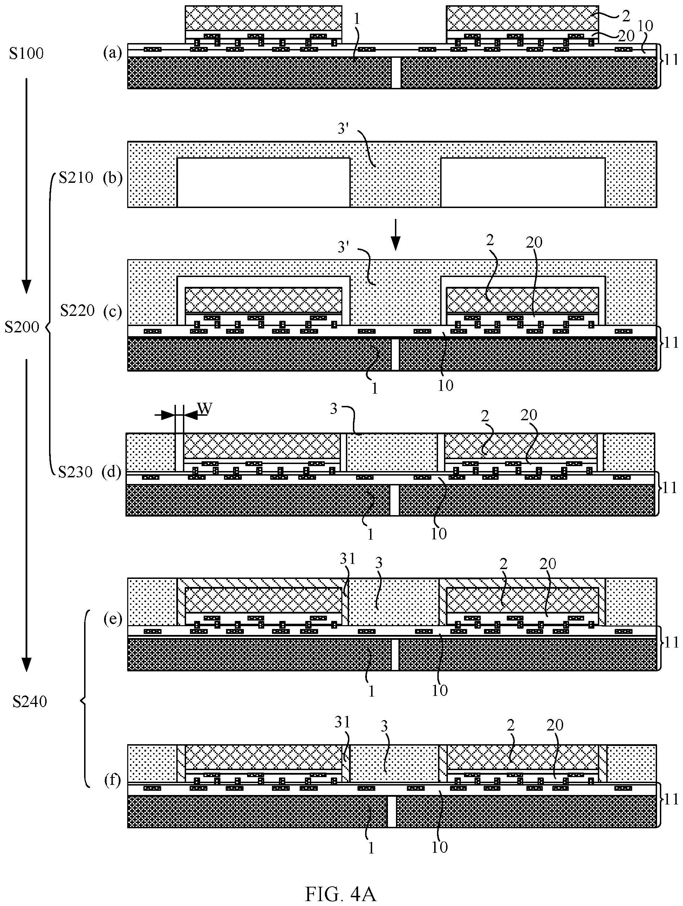

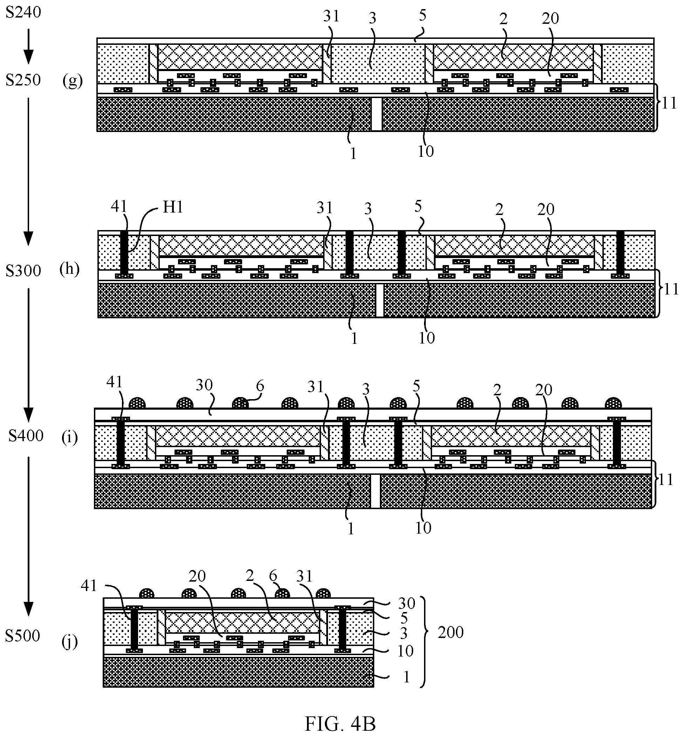

With reference to FIG. 4A and FIG. 4B, a fabrication method of the three-dimensional integrated circuit 200 as described above includes S100 to S500.

S100. As shown in (a) in FIG. 4A, provide plurality of second chips 2 and a first wafer 11 that is fabricated with a plurality of first chips 1, and bond the plurality of second chips 2 to the first wafer 11, so that at least one second chip 2 is bonded to each first chip 1.

Herein, the first chip 1 includes a second wiring layer 10, and the second chip 2 includes a third wiring layer 20. Bonding the second chip 2 with the first chip 1 is bonding the third wiring layer 20 with the second wiring layer 10, to implement an electrical connection between the second chip 2 and the first chip 1 by using the third wiring layer 20 and the second wiring layer 10.

Optionally, the part, exposed to a surface of a dielectric layer 101, of a metal pattern in the second wiring layer 10 does not protrude from the surface of the dielectric layer 101. The part, exposed to a surface of a dielectric layer 201, of a metal pattern in the third wiring layer 20 does not protrude from the surface of the dielectric layer 201. A bonding manner between the second wiring layer 10 and the third wiring layer 20 is direct bonding by dielectric layers. That is, the dielectric layer 201 in the third wiring layer 20 is directly bonded with the dielectric layer 101 in the second wiring layer 10, so that the part, exposed to the surface of the dielectric layer 201, of the metal pattern in the third wiring layer 20 is correspondingly coupled with the part, exposed to the surface of the dielectric layer 101, of the metal pattern in the second wiring layer 10.

Optionally, a part, exposed to the surface of the dielectric layer 101, of the metal pattern in the second wiring layer 10 protrudes from the surface of the dielectric layer 101, for example, exists in a manner of a bonding pad. Apart, exposed to the surface of the dielectric layer 201, of the metal pattern in the third wiring layer 20 protrudes from the surface of the dielectric layer 201, for example, exists in a manner of a bonding pad. A bonding manner between the second wiring layer 10 and the third wiring layer 20 is direct bonding by bonding pads. That is, a part, exposed to the surface of the dielectric layer 201, of the metal pattern in the third wiring layer 20 is directly aligned and bonded with the part, exposed to the surface of the dielectric layer 101, of the metal pattern in the second wiring layer 10.

Optionally, the part, exposed to the surface of the dielectric layer 101, of the metal pattern in the second wiring layer 10 is flush or approximately flush with the surface of the dielectric layer 101. The part, exposed to the surface of the dielectric layer 201, of the metal pattern in the third wiring layer 20 is flush or approximately flush with the surface of the dielectric layer 201. A bonding manner between the second wiring layer 10 and the third wiring layer 20 is hybrid bonding. That is, the dielectric layer 201 in the third wiring layer 20 is directly bonded with the dielectric layer 101 in the second wiring layer 10, and the part, exposed to the surface of the dielectric layer 201, of the metal pattern in the third wiring layer 20 is directly aligned and bonded with the part, exposed to the surface of the dielectric layer 101, of the metal pattern in the second wiring layer 10.

S200: Align and bond a first substrate 3 with the first wafer 11 bonded with the second chips 2, where first cavities Q1 are formed on the first substrate 3. The second chip 2 is accommodated in the first cavity Q1. The second chip 2 may be insulated from the first cavity Q1.

In some examples, the first substrate 3 is obtained by thinning a first original substrate preset with a plurality of first cavities Q1. As shown in (b), (c), and (d) in FIG. 4A, the aligning and bonding a first substrate 3 with the first wafer 11 bonded with the second chips 2 in S200 includes S210 to S230.

S210. As shown in (b) in FIG. 4A, provide a first original substrate 3'.

Herein, first cavities Q1 are formed on the first original substrate 3'. The first cavities Q1 and second chip 2 may be disposed in a one-to-one correspondence. The first cavity Q1 is used for accommodating the second chip 2, and a volume of the first cavity Q1 is greater than that of the second chip 2. A size of the first cavity Q1 in each direction is generally greater than or slightly greater than that of the corresponding second chip 2 in the same direction, and the size includes a length along an X direction, a width along a Y direction, and a depth or a thickness along a Z direction. The first cavity Q1 does not penetrate through the first original substrate 3', so that the first original substrate 3' may have a specific thickness. In this case, the first original substrate 3' can have good support strength, to facilitate bonding with the first wafer 11. Optionally, a shape of the first cavity Q1 is the same as or similar to that of the second chip 2.

Moreover, the first original substrate 3' is, for example, a silicon substrate or a glass substrate. The first cavity Q1 may be formed on the first original substrate 3' by using a dry etching process or a wet etching process.

S220. As shown in (c) in FIG. 4A, align and bond the first original substrate 3' with the first wafer 11, so that the second chip 2 is accommodated in the first cavity Q1 and there is a spacing W between the second chip 2 and the first cavity Q1.

Herein, the aligning and bonding the first original substrate 3' with the first wafer 11 is specifically: bringing the surface on which the first cavities Q1 are disposed in the first original substrate 3' to face the first wafer 11, and bonding the first original substrate 3' to the first wafer 11 in a fastening manner.

S230. As shown in (d) in FIG. 4A, thin the first original substrate 3' from a side, away from the first wafer 11, of the first original substrate 3' until the second chips 2 are exposed.

Herein, a thinning process for the first original substrate 3' may be a grinding process, an etching process, or a combination thereof. The etching process includes at least one of dry etching or wet etching. The thinned first original substrate 3' is the foregoing first substrate 3.

For example, along a thickness direction of the first original substrate 3', a grinding process is used for a part, farther from the second chip 2, of the first original substrate 3', and a dry etching process is used for a part, closer to the second chip 2, of the first original substrate 3'. The distance herein may be configured according to an actual requirement. The first original substrate 3' is thinned after bonded to the first wafer 11. Therefore, stress generated in the thinning process of the first original substrate 3' is slowly released, thereby avoiding damage to the first chip 1 due to large stress effect, and ensuring use reliability of the three-dimensional integrated circuit.

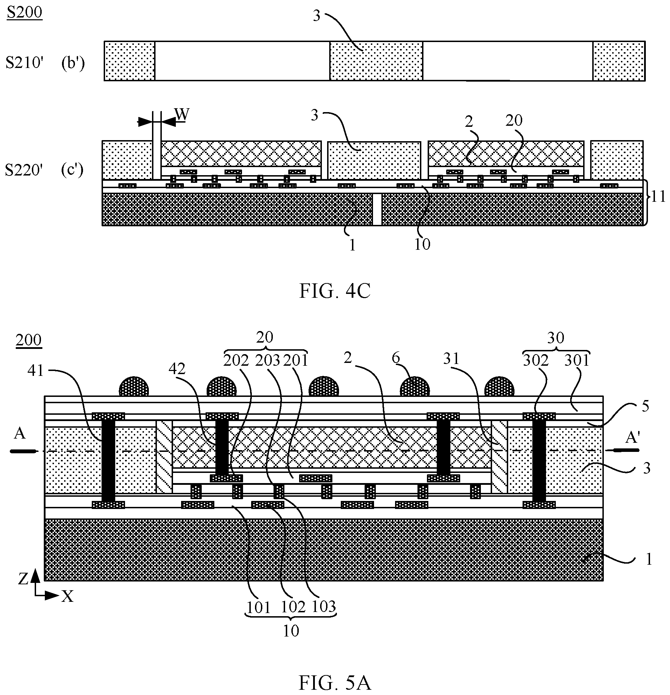

In some other examples, the first substrate 3 is a finished product preset with a plurality of first cavities Q1. That is, in the first substrate 3, the first cavities Q1 penetrate through the first substrate 3 along a depth direction (Z direction) of the first cavities Q1. A thickness of the first substrate 3 may be correspondingly designed according to a thickness of the second chip 2. As shown in (b') and (c') in FIG. 4C, the aligning and bonding a first substrate 3 with the first wafer 11 bonded with the second chips 2 in S200 includes S210' and S220'.

S210'. As shown in (b) in FIG. 4C, provide the first substrate 3.

Herein, a structure of the first substrate 3 is described in some of the foregoing embodiments. Details are not described herein again.

S220'. As shown in (c) in FIG. 4C, directly align and bond the first substrate 3 with the first wafer 11, so that the second chip 2 is exposed in the corresponding first cavity Q1, and there is a spacing W between the second chip 2 and the first cavity Q1. In this case, the thinning process in some of the foregoing embodiments does not need to be performed.

Insulation between the second chip 2 and the corresponding first cavity Q1 may be implemented by an insulating dielectric filled in the spacing W in a subsequent process. For example, based on some of the foregoing embodiments, each second chip 2 is located in a corresponding first cavity Q1 and is spaced from the first cavity Q1. Therefore, as shown in (e) in FIG. 4A, the fabrication method of a three-dimensional integrated circuit further includes S240: depositing an insulating dielectric 31 in the spacing W between each second chip 2 and the corresponding first cavity Q1. This step is especially applicable to the fabrication method of the three-dimensional integrated circuit 200 in which the first substrate 3 is a silicon substrate.

Herein, for a material and a deposition process of the insulating dielectric 31, refer to the foregoing content. Details are not described again.

In a process of depositing the insulating dielectric 31, the insulating dielectric may also be deposited on partial surfaces of the first substrate 3 and the second chip 2. Therefore, optionally, as shown in (f) in FIG. 4A, S240 further includes: after the deposition of the insulating dielectric 31 is completed, flattening, by grinding, chemical mechanical polishing, or the like, surfaces, away from the first chip 1, of the first substrate 3, the second chips 2, and the insulating dielectrics 31, for example, to locate on a same horizontal plane, or to keep corresponding regions flush by using the insulating dielectric 31.

S300. As shown in (h) in FIG. 4B, form plurality of first through holes H1 on the first substrate 3, and form a first conductor 41 in at least one first through hole H1. One end of the first conductor 41 is coupled to the first chip 1, for example, coupled to the metal pattern of the second wiring layer 10 in the first chip 1.

Herein, the first through hole H1 may be formed by an etching process, for example, a dry etching process. The first conductor 41 is insulated from the first substrate 3. In some embodiments in which the first substrate 3 is a silicon substrate, the first substrate 3 further needs to be insulated from metal patterns in wiring layers on two sides of the first substrate 3.

Based on this, optionally, before S300 is performed, that is, before the plurality of first through holes H1 are formed on the first substrate 3, as shown in (g) in FIG. 4B, the fabrication method of a three-dimensional integrated circuit further includes S250: forming an insulation layer 5 on the surfaces, away from the first wafer 11, of the first substrate 3 and the second chips 2. Optionally, after the plurality of first through holes H1 are formed on the first substrate 3, the fabrication method of a three-dimensional integrated circuit further includes: forming an insulating film (not shown in FIG. 4B) on an inner side wall of each first through hole H1.

Herein, for materials and deposition processes of the insulation layer 5 and the insulating film, refer to the foregoing content. Details are not described again.

S400. As shown in (i) in FIG. 4B, form a first wiring layer 30 on the surface, away from the first wafer 11, of the first substrate 3. At least a part of a metal pattern in the first wiring layer 30 is coupled to the other end of the corresponding first conductor 41.

Optionally, the first wiring layer 30 is an outermost layer of the three-dimensional integrated circuit 200. As shown in (i) in FIG. 4B, S400 further includes: forming a plurality of conductive micro-bumps 6 on the surface, away from the first wafer 11, of the first wiring layer 30, so that the conductive micro-bumps 6 are coupled to metal patterns in the first wiring layer 30. The conductive micro-bumps 6 can be used for implementing coupling between the three-dimensional integrated circuit 200 and the external component 100.

S500. As shown in (j) in FIG. 4B, scribe the first wafer 11 and a structure thereon to obtain a plurality of three-dimensional integrated circuits 200.

A plurality of cross scribe lines may be preset on the first wafer 11, to segment out a plurality of box regions by using the plurality of scribe lines, where each box region corresponds to a region where one first chip 1 is located. In this case, after the outermost structure of the three-dimensional integrated circuit 200 is fabricated, for example, after the plurality of conductive micro-bumps 6 are fabricated, the first wafer 11 is scribed along the scribe lines, to obtain the three-dimensional integrated circuits 200 in some of the foregoing embodiments.

The foregoing fabrication method of a three-dimensional integrated circuit achieves same technical effects as the three-dimensional integrated circuit in some of the foregoing embodiments. Details are not described herein again.

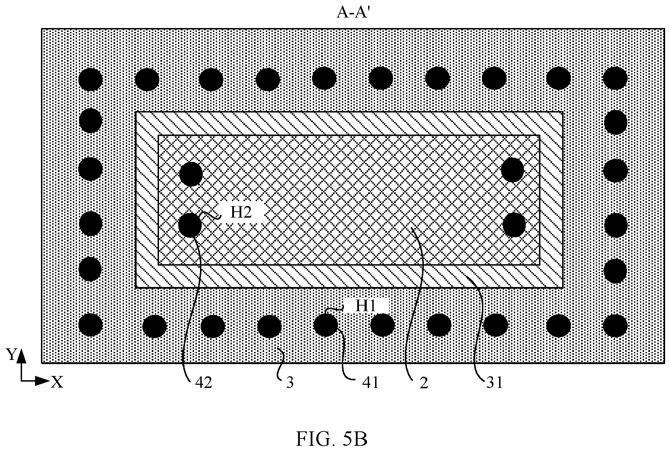

In some other embodiments, a structure of a three-dimensional integrated circuit 200 is shown in FIG. 5A and FIG. 5B. At least one second through hole H2 is further formed on the second chip 2. The three-dimensional integrated circuit 200 further includes at least one second conductor 42. The second conductor 42 is disposed in the second through hole H2. One end of the second conductor 42 is coupled to a metal pattern in the third wiring layer 20, and the other end of the second conductor 42 is coupled to a metal pattern in the first wiring layer 30. Similar to the first conductor 41, the second conductor 42 is made of a metal material filled in the second through hole H2, and is generally represented as a columnar metal object having a conductive function. The second conductor 42 can implement transmission of an electrical signal between the first wiring layer 30 and the third wiring layer 20.

When the substrate of the second chip 2 is a silicon substrate, an insulating film may be disposed on an inner wall of the second through hole H2, to ensure that the second conductor 42 is insulated from the silicon substrate, thereby improving use reliability of the second chip 2.

In this embodiment, a fabrication method of the three-dimensional integrated circuit 200 may be performed with reference to some of the foregoing embodiments, same fabrication steps are not described in detail again, and differences are described as follows.

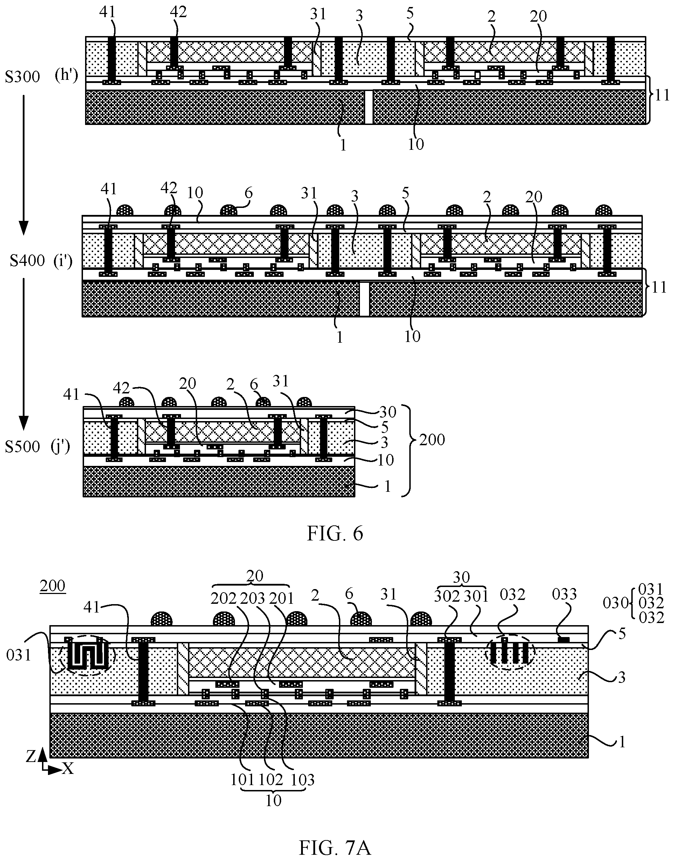

As shown in (h') in FIG. 6, S300 further includes: forming at least one second through hole H2 in at least one second chip 2, and forming a second conductor 42 in the second through hole H2, so that one end of the second conductor 42 is coupled to a metal pattern of the third wiring layer 30 in the second chip 2, and the other end of the second conductor 42 is exposed.

Correspondingly, as shown in (i') in FIG. 6, in S400, after the first wiring layer 30 is formed, at least a part of a metal pattern in the first wiring layer 30 may be coupled to the other end of the second conductor 42. As shown in (j') in FIG. 6, in S500, after the first wafer 11 and the structure thereon are scribed, the three-dimensional integrated circuit 200 shown in FIG. 5A may be obtained.

In addition, for example, the second through hole H2 and the first through hole H1 on the first substrate 3 may be etched in a dry etching process. The dry etching process generally includes steps such as photoresist coating, exposure, development, and dry etching molding. When the second through hole H2 differs from the first through hole H1 in depth and diameter, etching duration in the dry etching molding step corresponding to the second through hole H2 and the first through hole H1 may be different; or, the dry etching molding step corresponding to the second through hole H2 and the first through hole H1 may be completed in different time periods of the dry etching process respectively.

For example, the second conductor 42 and the first conductor 41 may also be fabricated in a metal deposition process. After the first conductor 41 and the second conductor 42 are formed, whether chemical mechanical polishing is required is determined as appropriate, to ensure that the first conductor 41 and the second conductor 42 have good conductive contact surfaces, which facilitate subsequent fabrication of the first wiring layer 30.

It should be noted that, in some of the foregoing embodiments, the metal patterns, the first conductors 41, the second conductors 42, and the conductive micro-bumps 6 in the wiring layers may be made of metal materials, for example, at least one of iridium, platinum, tungsten, nickel, cobalt, copper, aluminum, silicon-doped metal, or metal silicate. Therefore, the metal patterns, the first conductors 41, the second conductors 42, and the conductive micro-bumps 6 in the wiring layers all have good conductivity.

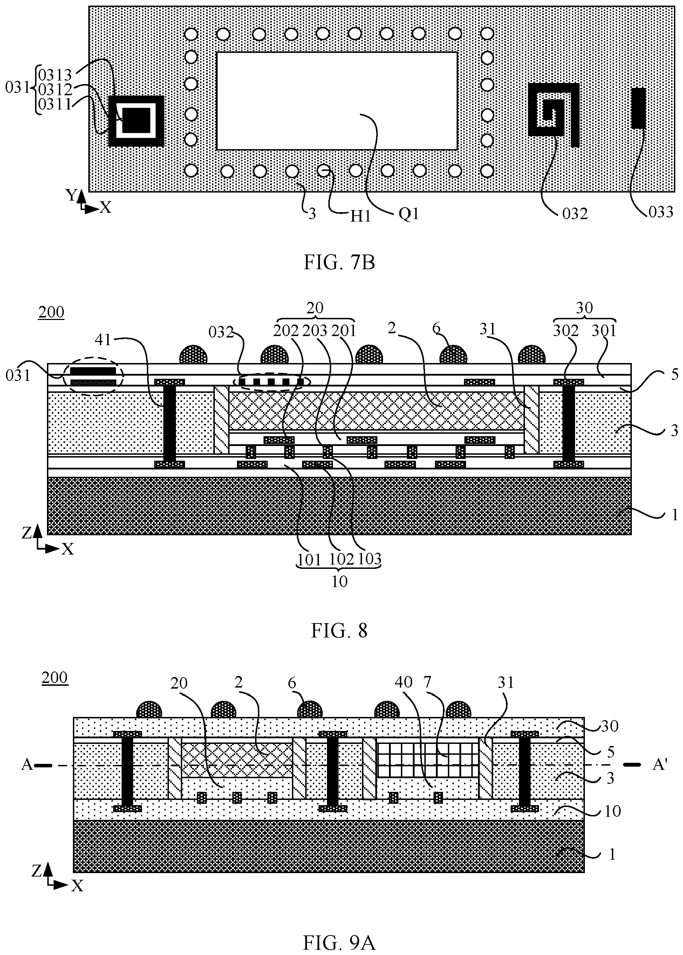

In some embodiments, with reference to FIG. 7A and FIG. 8, the three-dimensional integrated circuit 200 further includes at least one passive component 030. The passive component 030 may be a resistor 033, a capacitor 031, an inductor 032, or another similar electrical component. In this embodiment of this disclosure, a structure and a quantity of the passive component 030 are not limited, and may be configured according to an actual requirement. The passive component 030 may be coupled to a metal pattern in the first wiring layer 30, to form a functional circuit.

In some examples, as shown in FIG. 7A, based on the fact that the first substrate 3 is a substrate having specific support strength, such as a silicon substrate or a glass substrate, the passive component 030 may be fabricated in a trench on the surface, away from the first chip 1, of the first substrate 3, and is coupled to the metal pattern in the first wiring layer 30. Therefore, the three-dimensional integrated circuit 200 is light and thin.

For example, a plurality of trenches are disposed on the surface, away from the first chip 1, of the first substrate 3. The three-dimensional integrated circuit 200 includes a trench-type capacitor 031 and a trench-type inductor 032 that are disposed in the plurality of trenches separately.

With reference to FIG. 7A and FIG. 7B, the trench on the first substrate 3 may be fabricated after the insulation layer 5 is fabricated on the surface of the first substrate 3, or may be fabricated according to a coupling relationship between the passive component 030 and the metal pattern 302 in the first wiring layer 30 after an insulating film in the dielectric layer 301 of the first wiring layer 30 is fabricated.

One trench-type capacitor 031 may be fabricated in a plurality of adjacent trenches. For example, as shown in FIG. 7A and FIG. 7B, a first electrode 0311, an insulating film 0312, and a second electrode 0313 are sequentially stacked in at least two adjacent trenches, to form a trench-type capacitor 031. An orthographic projection of the second electrode 0313 on the first wiring layer 30 is located in an orthographic projection of the insulating film 0312 on the first wiring layer 30, the orthographic projection of the insulating film 0312 on the first wiring layer 30 is located in an orthographic projection of the first electrode 0311 on the first wiring layer 30, and there is a spacing between a boundary of the orthographic projection of the second electrode 0313 on the first wiring layer 30 and a boundary of the orthographic projection of the first electrode 0311 on the first wiring layer 30. Therefore, corresponding coupling of the first electrode 0311 and the second electrode 0313 with the metal pattern in the first wiring layer 30 is implemented. Herein, the orthographic projections of the first electrode 0311 and the second electrode 0313 in the trench-type capacitor 031 on the first wiring layer 30 may be in a same shape, for example, a circle or a rectangle.

One trench-type inductor 032 may be fabricated in one trench disposed in a planar spiral manner (that is, an orthographic projection of the trench on the first wiring layer 30 is spiral). For example, as shown in FIG. 7A and FIG. 7B, there is a spacing between orthographic projections of two ends of the trench-type inductor 032 on the first wiring layer 30, which facilitates corresponding coupling of the two ends of the trench-type inductor 032 with the metal pattern in the first wiring layer 30.

It should be added that, considering a structure of a resistor, in some examples in which the passive component 030 is a resistor, as shown in FIG. 7A, the resistor 033 may be directly fabricated on the side, away from the first chip 1, of the first substrate 3, for example, on a surface of the insulation layer 5 or in the first wiring layer 30. A corresponding trench does not need to be fabricated in the first substrate 3, thereby simplifying a fabrication process.

In this case, before the first wiring layer 30 is formed on the surface, away from the first wafer 11, of the first substrate 3, the fabrication method of a three-dimensional integrated circuit further includes: forming a plurality of trenches on the surface, away from the first chips 1, of the first substrate 3; and fabricating at least one passive component 030 in the plurality of trenches. After the first wiring layer 30 is fabricated, a metal pattern in the first wiring layer 30 may be correspondingly coupled to the passive component 030.

In some other examples, as shown in FIG. 8, the passive component 030 may be fabricated in the first wiring layer 30, for example, fabricated between some insulating films of the dielectric layer 301 in the first wiring layer 30, and correspondingly coupled to the metal pattern in the first wiring layer 30. That is, the passive component 030 may be integrated into the first wiring layer 30, thereby simplifying the fabrication process of the three-dimensional integrated circuit 200.

In this case, in the fabrication method of a three-dimensional integrated circuit, when the first wiring layer 30 is formed on the surface, away from the first wafer 11, of the first substrate 3, the method further includes: forming at least one passive component between some layers of the first wiring layer 30, so that the passive component is correspondingly coupled to the metal pattern in the first wiring layer 30.

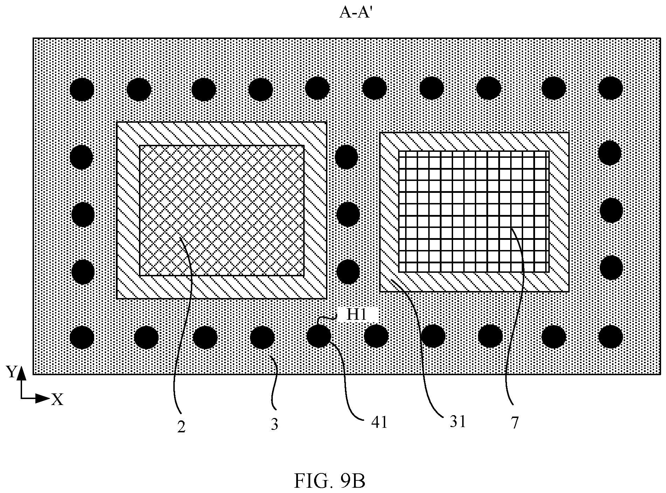

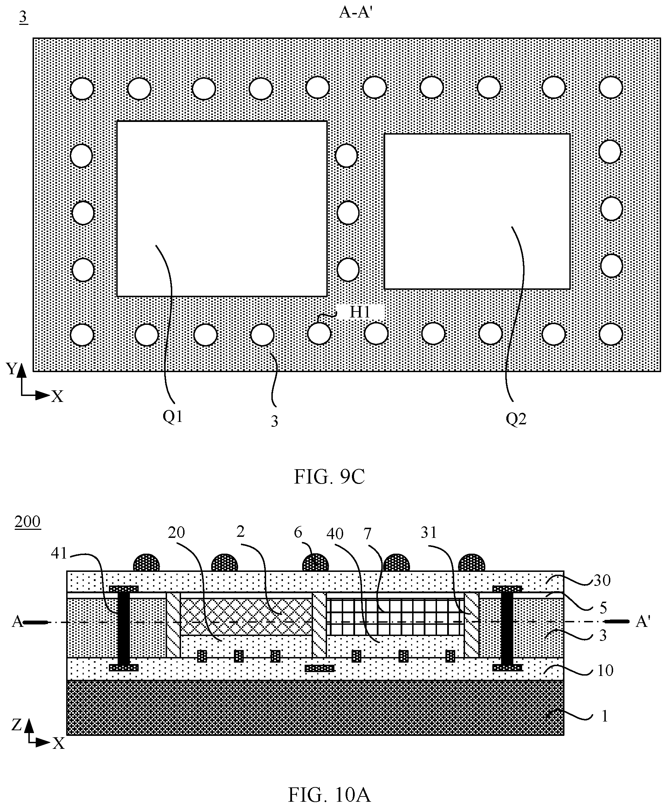

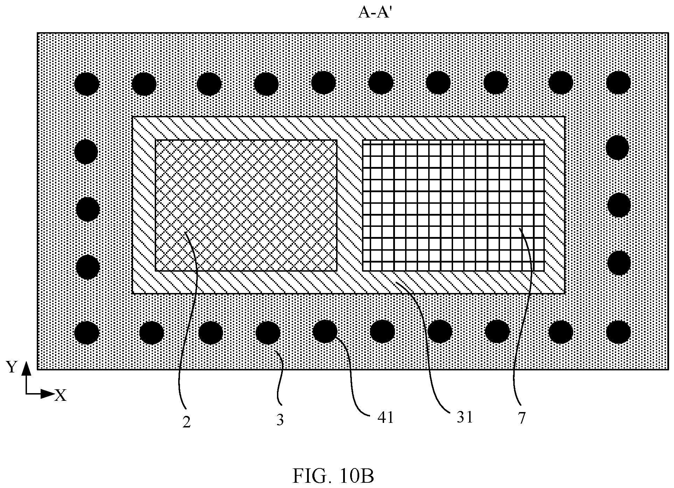

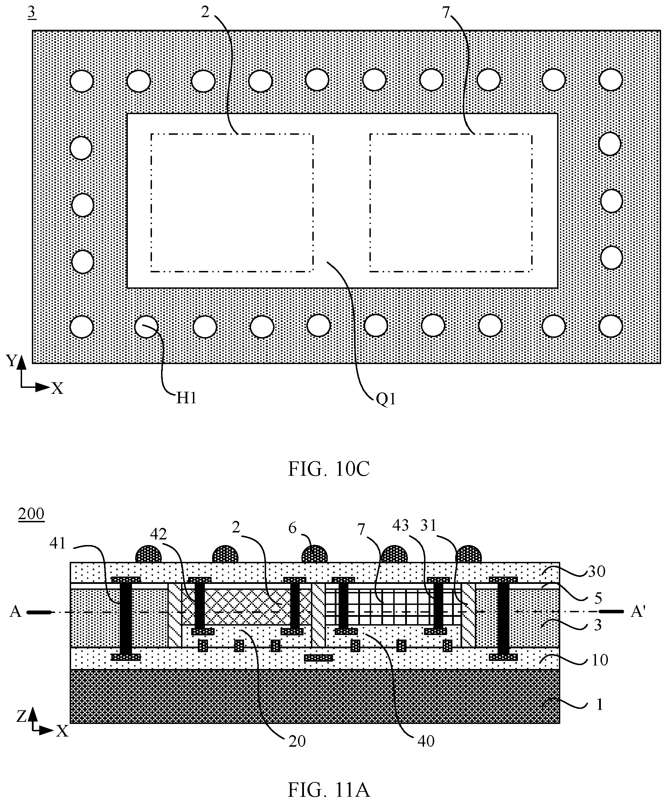

On the basis of the foregoing three-dimensional integrated circuit 200, according to the foregoing size relationship between the second chip 2 and the first chip 1, a third chip 7 having another function or size may be further bonded to the first chip 1. With reference to FIG. 9A and FIG. 10A, the three-dimensional integrated circuit 200 further includes at least one third chip 7. The third chip 7 is smaller than or farther smaller than the first chip 1, and at least one of a size or a function of the third chip 7 is different from that of the second chip 2. A quantity of the third chip 7 is not limited in this embodiment of this disclosure. FIG. 9A and FIG. 10A show only one third chip 7.

In some embodiments, as shown in FIG. 9A to FIG. 9C, the third chip 7 and the second chip 2 are bonded on a same side of the first chip 1. A second cavity Q2 is further formed on the first substrate 3. The second cavity Q2 is used for accommodating the third chip 7. The second cavity Q2 may be in a one-to-one correspondence with the third chip 7. A size of the second cavity Q2 is greater than or slightly greater than that of the corresponding third chip 7, and the size includes a length along an X direction, a width along a Y direction, and a depth or a thickness along a Z direction. In this case, each third chip 7 may be accommodated in a corresponding second cavity Q2, and is spaced from an inner side wall of the second cavity Q2. This facilitates aligning and bonding of the first substrate 3 with the first chip 1. In this embodiment of this disclosure, the first cavity Q1 matched with the second chip 2 and the second cavity Q2 matched with the third chip 7 are formed on the first substrate 3 separately, so that the first substrate 3 has high adaptability to the first chip 1, and this helps improve bonding precision between the first substrate 3 and the first chip 1.

Moreover, the third chip 7 is insulated from the inner side wall of the corresponding second cavity Q2. When the first substrate 3 is a silicon substrate, an insulating dielectric 31 may be filled between the second cavity Q2 and the corresponding third chip 7. When the three-dimensional integrated circuit 200 further includes an insulation layer 5 disposed between the first wiring layer 30 and the silicon substrate and between the first wiring layer 30 and the second chip 2, the insulation layer 5 is further located between the first wiring layer 30 and the third chip 7, so that the first wiring layer 30 and the third chip 7 can be well insulated by using the insulation layer 5.

In this embodiment of this disclosure, sizes of the first cavity Q1 and the second cavity Q2 may be the same or different. The first cavity Q1 and the second cavity Q2 may be etched in a same process. Distribution of the first cavity Q1 and the second cavity Q2 on the first substrate 3 may be determined according to bonding positions of the corresponding second chip 2 and the corresponding third chip 7 on the first chip 1. For example, as shown in FIG. 9C, the first cavity Q1 and the second cavity Q2 are arranged adjacently, and the plurality of first through holes H1 are evenly distributed on peripheries of the corresponding first cavity Q1 and the corresponding second cavity Q2.

In this embodiment, the fabrication method of a three-dimensional integrated circuit 200 may be performed with reference to some of the foregoing embodiments, and only a step of bonding the third chip 7 with the first chip 1 and a step of fabricating the first substrate 3 that includes both the first cavity Q1 and the second cavity Q2 need to be correspondingly added. For example, before the first substrate 3 is aligned and bonded to the first wafer 11 bonded with the second chips 2, the fabrication method of a three-dimensional integrated circuit further includes: providing a plurality of third chips 7, and bonding the third chips 7 and the second chips 2 to the first wafer 11 at a same layer, so that at least one third chip 7 is further bonded to one first chip 7. Correspondingly, the aligning and bonding a first substrate 3 to the first wafer 11 bonded with the second chips 2 further includes: enabling the third chip 7 to be accommodated in the second cavity Q2 on the first substrate 3.

In some other embodiments, as shown in FIG. 10A to FIG. 10C, the third chip 7 and the second chip 2 are bonded on a same side of the first chip 1. At least one third chip 7 may be further accommodated in each first cavity Q1. That is, one second chip 2 may correspond to one or more third chips 7, and the one or more third chips 7 are located in the corresponding first cavity Q1.

Optionally, the third chip 7 is in a one-to-one correspondence with the second chip 2, and the third chip 7 is disposed on a side of the second chip 2. The third chip 7 is insulated from the second chip 2 and the inner side wall of the first cavity Q1 separately. When the first substrate 3 is a silicon substrate, an insulating dielectric 31 is filled between the first cavity Q1 and the corresponding third chip 7, and between the third chip 7 and the corresponding second chip 2.

Optionally, one second chip 2 corresponds to a plurality of third chips 7, and the plurality of third chips 7 are evenly distributed on a periphery of the second chip 2. Each third chip 7 is insulated from the corresponding second chip 2 and the inner side wall of the first cavity Q1. Any two third chips 7 are also insulated from each other. When the first substrate 3 is a silicon substrate, an insulating dielectric 31 is filled between the first cavity Q1 and the corresponding third chip 7, between the third chip 7 and the corresponding second chip 2, and between any two third chips 7.

The third chip 7 and the second chip 2 are jointly accommodated in the first cavity Q1 of the first substrate 3, to reduce a spacing between the second chip 2 and the third chip 7, thereby further implementing a small size and high density of the three-dimensional integrated circuit.

In this embodiment, the fabrication method of a three-dimensional integrated circuit 200 may be performed with reference to some of the foregoing embodiments, and only a step of bonding the third chip 7 with the first chip 1 needs to be correspondingly added. For example, before the first substrate 3 is aligned and bonded to the first wafer 11 bonded with the second chips 2, the fabrication method of a three-dimensional integrated circuit further includes: providing a plurality of third chips 7, and bonding the third chips 7 and the second chips 2 to the first wafer 11 at a same layer, so that at least one third chip 7 is further bonded to one first chip 7.

Moreover, when the three-dimensional integrated circuit 200 further includes an insulation layer 5 disposed between the first wiring layer 30 and the silicon substrate and between the first wiring layer 30 and the second chip 2, the insulation layer 5 is further located between the first wiring layer 30 and the third chip 7, to well insulate the first wiring layer 30 and the third chip 7.

It should be added that, with reference to FIG. 9A and FIG. 10A, in some embodiments, the third chip 7 includes a fourth wiring layer 40. Bonding between the third chip 7 and the first chip 1 is represented as bonding between the fourth wiring layer 40 in the third chip 7 and the second wiring layer 10 in the first chip 1.

Herein, a structure of the fourth wiring layer 40 is similar to structures of some of the foregoing wiring layers. Bonding between the fourth wiring layer 40 and the second wiring layer 10 refers to an electrical connection between a metal pattern in the fourth wiring layer 40 and a metal pattern in the second wiring layer 10. For a bonding manner between the third chip 7 and the first chip 1, refer to the bonding manner between the second chip 2 and the first chip 1. Details are not described herein.

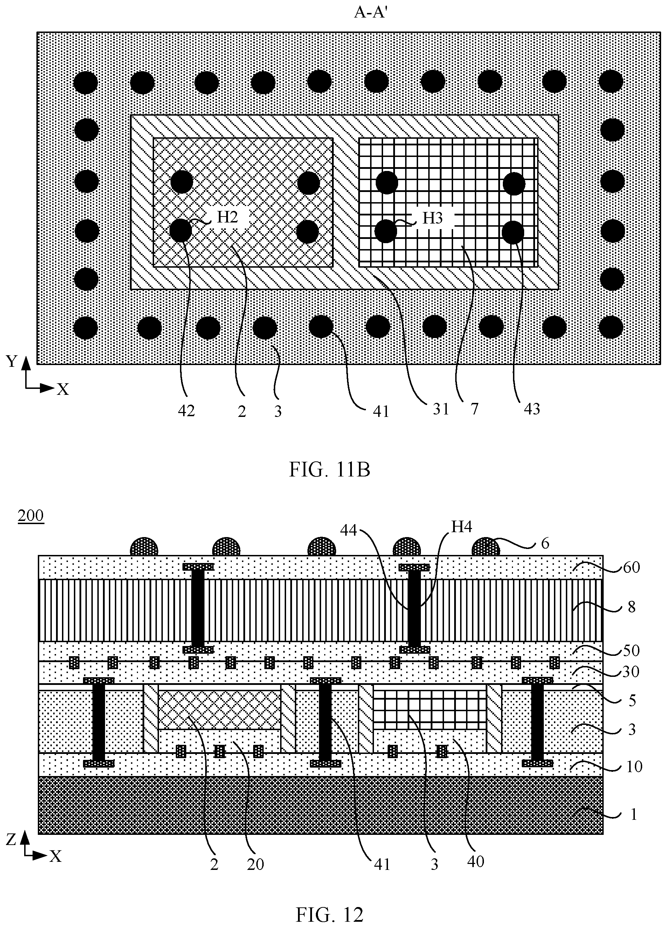

In some embodiments, with reference to FIG. 11A and FIG. 11B, similar to the second chip 2, at least one third through hole H3 may also be formed on the third chip 7, to form a third conductor 43 in the third through hole H3. Similar to the second conductor 42, the third conductor 43 is made of a metal material filled in the third through hole H3, and is generally represented as a columnar metal object having a conductive function. One end of the third conductor 43 is coupled to the metal pattern in the fourth wiring layer 40, and the other end of the third conductor 43 is coupled to the metal pattern in the first wiring layer 30. Transmission of an electrical signal between the fourth wiring layer 40 and the first wiring layer 30 may be implemented by using the third conductor 43. Herein, the third through hole H3 may be fabricated with reference to the step of forming a second through hole H2 on the second chip 2, and the third conductor 43 may be fabricated with reference to the step of fabricating a second conductor 42. Details are not described herein again.

It may be understood that, on the basis of the foregoing three-dimensional integrated circuit 200, one or more layers of chips may be further stacked on the side, away from the first chips 1, of the first wiring layer 30 along a thickness direction (a Z direction in FIG. 12) of the first chips 1. This is not limited in this embodiment of this disclosure. One layer of chips is stacked as an example for description below. For stacking of a plurality of layers of chips, refer to content in some of the following embodiments.

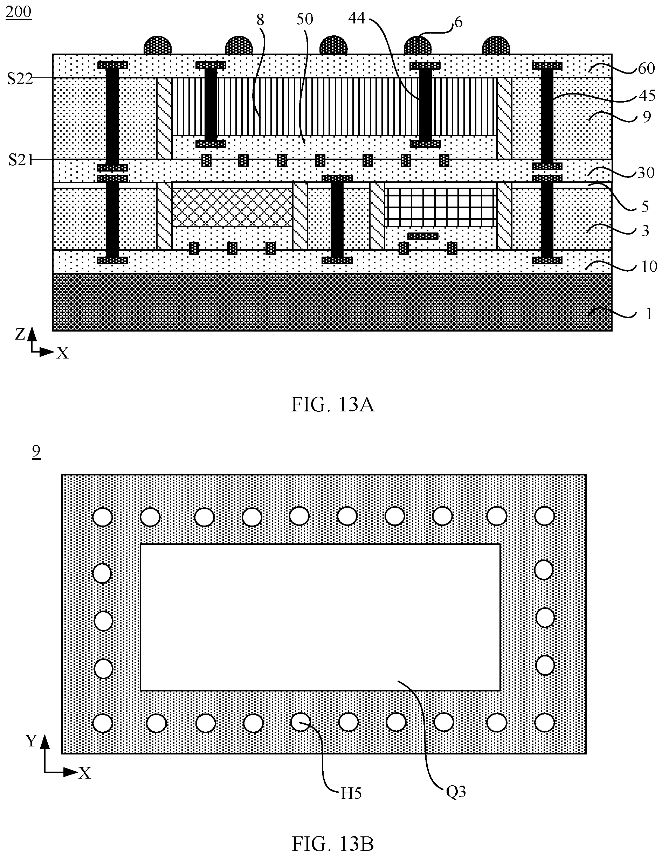

With reference to FIG. 12 and FIG. 13A, the three-dimensional integrated circuit 200 further includes at least one fourth chip 8 bonded to the side, away from the first chip 1, of the first wiring layer 30. A bonding manner between the fourth chip 8 and the first wiring layer 30 is related to a structure of the fourth chip 8. For example, the fourth chip 8 is directly fabricated on a second wafer, and bonding between the fourth chip 8 and the first wiring layer 30 may be bonding between the second wafer and the first wiring layer 30. Alternatively, for another example, the fourth chip 8 is an independent chip with a structure similar to that of the second chip 2. For bonding between the fourth chip 8 and the first wiring layer 30, refer to the bonding between the second chip 2 and the first chip 1. A quantity of the fourth chip 8 is not limited in this embodiment of this disclosure. FIG. 12 and FIG. 13A show only one fourth chip 8. In addition, for a fabrication method of the three-dimensional integrated circuit 200 including the fourth chip 8, refer to some of the foregoing embodiments, and only a step of bonding the fourth chip 8 and the first wiring layer 30 needs to be correspondingly added. For example, before the first wafer 11 and the structure thereon are scribed along the scribe lines, the fabrication method of a three-dimensional integrated circuit further includes: providing a plurality of fourth chips 8, and bonding the fourth chips 8 to a surface, away from the first chips 1, of the first wiring layer 30, so that the fourth chips 8 are correspondingly coupled to metal patterns in the first wiring layer 30, and an orthographic projection of the fourth chip 8 on the first wafer 11 is located in an orthographic projection of the first chip 1 on the first wafer 11.

In some embodiments, as shown in FIG. 12, the fourth chip 8 is an independent chip. A size of the fourth chip 8 may be the same as or slightly smaller than that of the first chip 1. The fourth chip 8 includes a fifth wiring layer 50 bonded with the first wiring layer 30. For bonding between the fifth wiring layer 50 and the first wiring layer 30, refer to the foregoing bonding between the second wiring layer 10 and the third wiring layer 20. Details are not described herein again.

Optionally, the fourth chip 8 further includes at least one fourth through hole H4. The three-dimensional integrated circuit 200 further includes at least one fourth conductor 44, and a sixth wiring layer 60 formed on a surface, away from the first wiring layer 30, of the fourth chip 8. The fourth conductor 44 is disposed in the fourth through hole H4. The fourth conductor 44 may be made of a metal material filled in the fourth through hole H4, and is generally represented as a columnar metal object having a conductive function. One end of the fourth conductor 44 is coupled to a metal pattern in the fifth wiring layer 50, and the other end of the fourth conductor 44 is coupled to a metal pattern in the sixth wiring layer 60. The fourth conductor 44 may be used for implementing transmission of an electrical signal between the fourth chip 8 and the sixth wiring layer 60.

In this case, on the basis of the foregoing fabrication method of a three-dimensional integrated circuit, before the first wafer and the structure thereon are scribed along the scribe lines, the fabrication method of a three-dimensional integrated circuit further includes: forming at least one fourth through hole H4 on at least one fourth chip 8; forming a fourth conductor 44 in the fourth through hole H4, so that one end of the fourth conductor 44 is coupled to the fifth wiring layer 50, and the other end of the fourth conductor 44 is exposed on the surface, away from the first wiring layer 30, of the fourth chip 8; and forming a sixth wiring layer 60 on the surface, away from the first wiring layer 30, of the fourth chip 8, so that a metal pattern in the sixth wiring layer 60 is coupled to the other end of the fourth conductor 44.

In some other embodiments, as shown in FIG. 13A, the fourth chip 8 is an independent chip. The fourth chip 8 is smaller than the first chip 1. The three-dimensional integrated circuit 200 further includes a second substrate 9 and a sixth wiring layer 60. The second substrate 9 is, for example, a silicon substrate or a glass substrate. The second substrate 9 and the fourth chip 8 are separately bonded to the same side, away from the first chip 1, of the first wiring layer 30. The fourth chip 8 includes a fifth wiring layer 50. Bonding between the fourth chip 8 and the first wiring layer 30 is represented as bonding between the fifth wiring layer 50 and the first wiring layer 30. For details, refer to the foregoing bonding between the second wiring layer 10 and the third wiring layer 20. Details are not described herein again.

A structure of the second substrate 9 is shown in FIG. 13B, and a third cavity Q3 is formed on the second substrate 9. The third cavity Q3 is used for accommodating the fourth chip 8. The third cavity Q3 may be in a one-to-one correspondence with the fourth chip 8. A size of the third cavity Q3 is generally greater than or slightly greater than that of the corresponding fourth chip 8, and the size includes a length along an X direction, a width along a Y direction, and a depth or a thickness along a Z direction. In this case, the fourth chip 8 may be accommodated in the corresponding third cavity Q3, and there is a spacing between each fourth chip 8 and the corresponding third cavity Q3. This facilitates aligning and bonding of the second substrate 9 with the first wiring layer 30. Optionally, a shape of the third cavity Q3 is the same as or similar to that of the fourth chip 8.

Moreover, the fourth chip 8 is insulated from an inner side wall of the corresponding third cavity Q3. When the second substrate 9 is a silicon substrate, an insulating dielectric 31 may be filled between the third cavity Q3 and the corresponding fourth chip 8.

Continue to refer to FIG. 13A and FIG. 13B. The surface, bonded with the first wiring layer 30, of the second substrate 9 is a first surface S21, and the surface, away from the first wiring layer 30, of the second substrate 9 is a second surface S22. That is, the first surface S21 and the second surface S22 of the second substrate 9 are opposite. The sixth wiring layer 60 is located on the second surface S22 of the second substrate 9. At least one fifth through hole H5 that penetrates through the first surface S21 and the second surface S22 of the second substrate 9 is further formed on the second substrate 9. The three-dimensional integrated circuit 200 further includes at least one fifth conductor 45. The fifth conductor 45 is disposed in the fifth through hole H5. The fifth conductor 45 may be made of a metal material filled in the fifth through hole H5, and is generally represented as a columnar metal object having a conductive function. One end of the fifth conductor 45 is coupled to a metal pattern in the first wiring layer 30, and the other end of the fifth conductor 45 is coupled to a metal pattern in the sixth wiring layer 60. The fifth conductor 45 can be used for implementing transmission of an electrical signal between the first wiring layer 30 and the sixth wiring layer 60.

In this case, on the basis of the foregoing fabrication method of a three-dimensional integrated circuit, before the first wafer and the structure thereon are scribed along the scribe lines, the fabrication method of a three-dimensional integrated circuit further includes: aligning and bonding a second substrate 9 to the first wiring layer 30 bonded with the fourth chip 8, so that the fourth chip 8 is accommodated in the third cavity Q3 in the second substrate 9; forming a plurality of fifth through holes H5 on the second substrate 9; forming a fifth conductor 45 in the fifth through hole H5, so that one end of the fifth conductor 45 is coupled to a metal pattern in the first wiring layer 30, and the other end of the fifth conductor 45 is exposed; and forming a sixth wiring layer 60 on the surface, away from the first wafer 11, of the second substrate 9, so that a metal pattern in the sixth wiring layer 60 is correspondingly coupled to the other end of the fifth conductor 45.

It may be understood that, in some embodiments, a fourth through hole H4 may alternatively be disposed on the fourth chip 8, and a fourth conductor 44 may alternatively be disposed in the fourth through hole H4, to implement transmission of an electrical signal between the fifth wiring layer 50 and the sixth wiring layer 60 by using the fourth conductor 44. This is not limited in embodiments of this disclosure.

On the basis of some of the foregoing embodiments, optionally, as shown in FIG. 12 and FIG. 13A, the three-dimensional integrated circuit 200 further includes at least one conductive micro-bump 6. A structure of the conductive micro-bump 6 is described above. When the sixth wiring layer 60 is an outermost layer of the three-dimensional integrated circuit 200, the conductive micro-bump 6 is formed on a surface, away from the fourth chip 8, of the sixth wiring layer 60, and is coupled to a metal pattern in the sixth wiring layer 60, to implement coupling between the three-dimensional integrated circuit 200 and the external component 100.

Correspondingly, on the basis of the foregoing fabrication method of a three-dimensional integrated circuit, before the first wafer and the structure thereon are scribed along the scribe lines, the fabrication method of a three-dimensional integrated circuit further includes: forming at least one conductive micro-bump 6 on the surface, away from the fourth chip 8, of the sixth wiring layer 60, so that the conductive micro-bump 6 is coupled to a metal pattern in the sixth wiring layer.

It should be added that, in some embodiments in which the second substrate 9 is a silicon substrate, an insulating film (not shown in FIG. 13A) may be formed on an inner side wall of the fifth through hole H5, to ensure that the fifth conductor 45 is insulated from the silicon substrate. Further, the second substrate 9 is insulated from metal patterns in wiring layers on two sides of the second substrate 9. That is, the parts, exposed to the surface of the dielectric layer, of the metal patterns in the first wiring layer 30 and the sixth wiring layer 60 are not in direct contact with the silicon substrate. If the regions, in direct contact with the silicon substrate, of the first wiring layer 30 and the sixth wiring layer 60 have exposed parts of the metal patterns, an insulation layer shall be further disposed between the first wiring layer 30 and the silicon substrate and between the sixth wiring layer 60 and the silicon substrate for insulation, to improve use reliability of the three-dimensional integrated circuit 200.

Moreover, in this embodiment of this disclosure, technical effects that can be achieved by the second substrate 9 are the same as the foregoing technical effects of the first substrate 3. This helps simplify a fabrication process of the three-dimensional integrated circuit 200 based on a small size and high density, to improve production efficiency and reduce production costs. Details are not described herein again.

In conclusion, in a three-dimensional integrated circuit, more chips having different functions, different sizes, and different fabrication processes may be stacked in a three-dimensional direction according to the stacking manners of different chips in some of the foregoing embodiments, to simplify a fabrication process of the three-dimensional integrated circuit based on a small size and high density, thereby improving production efficiency of the three-dimensional integrated circuit and reducing production costs of the three-dimensional integrated circuit.

In the descriptions of the foregoing implementations, specific features, structures, materials, or characteristics may be combined in a suitable manner in any one or more embodiments or examples.

The foregoing descriptions are only specific implementations of this disclosure, but are not intended to limit the protection scope of this disclosure. Any variation or replacement readily conceived by a person skilled in the art within the technical scope disclosed in this disclosure shall fall within the protection scope of this disclosure. Therefore, the protection scope of this disclosure shall be subject to the protection scope of the claims.

## Claims

1. A three-dimensional integrated circuit, comprising: a first chip, at least one second chip, a first substrate, a first wiring layer, and at least one first conductor, wherein
the first chip is bonded to a first surface of the first substrate;
a first cavity is formed on the first substrate, and the second chip is accommodated in the first cavity and bonded with the first chip;
the first wiring layer is formed on a second surface of the first substrate, wherein the first surface and the second surface of the first substrate are opposite;
a first through hole that penetrates through the first surface and the second surface of the first substrate is further formed on the first substrate, and the first conductor is disposed in the first through hole; and
the first wiring layer and the first chip are coupled by using the first conductor

2. The three-dimensional integrated circuit according to claim 1, wherein the first substrate is a silicon substrate; and the three-dimensional integrated circuit further comprises:
an insulating dielectric filled between the second chip and an inner side wall of the first cavity; and
an insulating film formed on an inner side wall of the first through hole.

3. The three-dimensional integrated circuit according to claim 1, wherein the first substrate is a silicon substrate; and
the three-dimensional integrated circuit further comprises: an insulation layer disposed between the first wiring layer and the silicon substrate and between the first wiring layer and the second chip.

4. The three-dimensional integrated circuit according to claim 1, further comprising at least one passive component, wherein the at least one passive component comprises at least one of a resistor, a capacitor, and an inductor; and
the passive component is formed in a trench on a surface, away from the first chip, of the first substrate, and is coupled to a metal pattern in the first wiring layer; or
the passive component is formed in the first wiring layer, and is coupled to a metal pattern in the first wiring layer.

5. The three-dimensional integrated circuit according to claim 1, wherein the first chip comprises a second wiring layer, and the second chip comprises a third wiring layer;
the third wiring layer is bonded with the second wiring layer; and
an end, coupled to the first chip, of the first conductor is coupled to a metal pattern in the second wiring layer.

6. The three-dimensional integrated circuit according to claim 5, wherein the second chip comprises at least one second through hole, and the three-dimensional integrated circuit further comprises at least one second conductor, wherein
the second conductor is disposed in the second through hole, one end of the second conductor is coupled to a metal pattern in the third wiring layer, and the other end of the second conductor is coupled to a metal pattern in the first wiring layer

7. The three-dimensional integrated circuit according to any one of claims 1 to 6, further comprising at least one third chip, wherein
a second cavity is further formed on the first substrate, and the third chip is accommodated in the second cavity and bonded with the first chip; and
the first wiring layer is located on a side, away from the first chip, of the third chip.

8. The three-dimensional integrated circuit according to claim 7, wherein the first substrate is the silicon substrate; and the three-dimensional integrated circuit further comprises:
an insulating dielectric filled between the third chip and an inner side wall of the second cavity; and
an insulation layer disposed between the first wiring layer and the silicon substrate, between the first wiring layer and the second chip, and between the first wiring layer and the third chip.

9. The three-dimensional integrated circuit according to any one of claims 1 to 6, further comprising at least one third chip, wherein
the third chip is accommodated in the first cavity and bonded with the first chip, and the third chip is insulated from the second chip accommodated in the same first cavity as the third chip; and
the first wiring layer is located on a side, away from the first chip, of the third chip.

10. The three-dimensional integrated circuit according to claim 9, wherein the first substrate is the silicon substrate; and the three-dimensional integrated circuit further comprises:
an insulating dielectric filled between any two of the second chip, the third chip, and the inner side wall of the first cavity; and
an insulation layer disposed between the first wiring layer and the silicon substrate, between the first wiring layer and the second chip, and between the first wiring layer and the third chip.

11. The three-dimensional integrated circuit according to any one of claims 7 to 10, wherein the first chip comprises the second wiring layer; the third chip comprises a fourth wiring layer; and the fourth wiring layer is bonded with the second wiring layer.

12. The three-dimensional integrated circuit according to claim 11, wherein the third chip comprises at least one third through hole; and the three-dimensional integrated circuit further comprises at least one third conductor, wherein
the third conductor is disposed in the third through hole, one end of the third conductor is coupled to a metal pattern in the fourth wiring layer, and the other end of the third conductor is coupled to the metal pattern in the first wiring layer.

13. The three-dimensional integrated circuit according to any one of claims 1 to 12, further comprising at least one conductive micro-bump, wherein the conductive micro-bump is disposed on a surface, away from the first chip, of the first wiring layer, and is coupled to the metal pattern in the first wiring layer.

14. The three-dimensional integrated circuit according to any one of claims 1 to 12, further comprising at least one fourth chip, wherein the fourth chip is bonded to a surface, away from the first chip, of the first wiring layer, and is coupled to the metal pattern in the first wiring layer

15. The three-dimensional integrated circuit according to claim 14, wherein
the fourth chip comprises a fifth wiring layer, and the fifth wiring layer is bonded with the first wiring layer;
the fourth chip further comprises at least one fourth through hole; and
the three-dimensional integrated circuit further comprises: at least one fourth conductor, and a sixth wiring layer formed on a surface, away from the first wiring layer, of the fourth chip, wherein
the fourth conductor is disposed in the fourth through hole, one end of the fourth conductor is coupled to a metal pattern in the fifth wiring layer, and the other end of the fourth conductor is coupled to a metal pattern in the sixth wiring layer.

16. The three-dimensional integrated circuit according to claim 14, further comprising: a second substrate, a sixth wiring layer, and at least one fifth conductor, wherein
a third cavity is formed on the second substrate, and the fourth chip is accommodated in the third cavity;
a first surface of the second substrate is bonded to a surface, away from the first substrate, of the first wiring layer;
the sixth wiring layer is formed on a second surface of the second substrate, wherein the first surface and the second surface of the second substrate are opposite;
a fifth through hole that penetrates through the first surface and the second surface of the second substrate is further formed on the second substrate; and
the fifth conductor is disposed in the fifth through hole, one end of the fifth conductor is coupled to the metal pattern in the first wiring layer, and the other end of the fifth conductor is coupled to a metal pattern in the sixth wiring layer.

17. The three-dimensional integrated circuit according to claim 15 or 16, further comprising at least one conductive micro-bump, wherein
the conductive micro-bump is disposed on a surface, away from the fourth chip, of the sixth wiring layer, and is coupled to the metal pattern in the sixth wiring layer

18. An electronic device, comprising:
at least one three-dimensional integrated circuit according to any one of claims 1 to 17; and
an external component coupled to the three-dimensional integrated circuit, wherein the external component comprises at least one of an interposer and a packaging substrate.

19. A fabrication method of a three-dimensional integrated circuit, comprising:
providing a plurality of second chips and a first wafer that is fabricated with a plurality of first chips, and bonding the second chips to the first wafer, so that at least one of the second chips is bonded to one of the first chips;
aligning and bonding a first substrate to the first wafer bonded with the second chips, so that the second chip is accommodated in a first cavity on the first substrate;
forming a plurality of first through holes on the first substrate;
forming a first conductor in the first through hole, so that one end of the first conductor is coupled to the first chip, and the other end of the first conductor is exposed;
forming a first wiring layer on a surface, away from the first wafer, of the first substrate, wherein a metal pattern in the first wiring layer is coupled to the other end of the first conductor; and
scribing the first wafer and a structure thereon along scribe lines to obtain a plurality of three-dimensional integrated circuits.

20. The fabrication method of a three-dimensional integrated circuit according to claim 19, wherein the aligning and bonding a first substrate to the first wafer bonded with the second chips further comprises:
providing a first original substrate, wherein the first cavity is formed on the first original substrate, the first cavity does not penetrate through the first original substrate, a volume of the first cavity is greater than that of the second chip, and the first cavity can accommodate the second chip;
aligning and bonding the first original substrate to the first wafer bonded with the second chips, so that the second chip is accommodated in the first cavity on the first original substrate, and there is a spacing between the second chip and the first cavity; and
thinning the first original substrate from a side, away from the first wafer, of the first original substrate until the second chip is exposed, wherein the thinned first original substrate is the first substrate.

21. The fabrication method of a three-dimensional integrated circuit according to claim 20, wherein a thinning process for the first original substrate comprises at least one of a grinding process and an etching process; and the etching process comprises at least one of dry etching and wet etching.

22. The fabrication method of a three-dimensional integrated circuit according to claim 20, wherein before the plurality of first through holes are formed on the first substrate, the fabrication method of a three-dimensional integrated circuit further comprises:
depositing an insulating dielectric in the spacing between the second chip and the first cavity.

23. The fabrication method of a three-dimensional integrated circuit according to claim 19, wherein the first substrate is a silicon substrate; and the fabrication method of a three-dimensional integrated circuit further comprises:
before forming a plurality of first through holes on the first substrate, forming an insulation layer on surfaces, away from the first wafer, of the first substrate and the second chip; and
after forming the plurality of first through holes on the first substrate, forming an insulating film on an inner side wall of the first through hole.

24. The fabrication method of a three-dimensional integrated circuit according to any one of claims 19 to 23, wherein
before the first wiring layer is formed on the surface, away from the first wafer, of the first substrate, the fabrication method of a three-dimensional integrated circuit further comprises:
forming a plurality of trenches on a surface, away from the first chip, of the first substrate; and
forming at least one passive component in the plurality of trenches, so that the metal pattern in the first wiring layer is further coupled to the passive component, wherein the at least one passive component comprises at least one of a resistor, a capacitor, and an inductor.

25. The fabrication method of a three-dimensional integrated circuit according to any one of claims 19 to 23, wherein
the forming a first wiring layer on a surface, away from the first wafer, of the first substrate further comprises:
forming at least one passive component between some layers in the first wiring layer, so that the passive component is coupled to the metal pattern in the first wiring layer, wherein the at least one passive component comprises at least one of a resistor, a capacitor, and an inductor.

26. The fabrication method of a three-dimensional integrated circuit according to any one of claims 19 to 23, further comprising:
forming at least one second through hole on at least one of the second chips; and
forming a second conductor in the second through hole, so that one end of the second conductor is coupled to a third wiring layer in the second chip, and the other end of the second conductor is exposed, wherein
after the first wiring layer is formed, the metal pattern in the first wiring layer is coupled to the other end of the second conductor

27. The fabrication method of a three-dimensional integrated circuit according to any one of claims 19 to 23, wherein
before the first substrate is aligned and bonded to the first wafer bonded with the second chips, the fabrication method of a three-dimensional integrated circuit further comprises: providing a plurality of third chips, and bonding the third chips and the second chips to the first wafer at a same layer, so that at least one of the third chips is further bonded to one of the first chips; and
the aligning and bonding a first substrate to the first wafer bonded with the second chips further comprises: enabling the third chip to be accommodated in the first cavity or the second cavity on the first substrate.

28. The fabrication method of a three-dimensional integrated circuit according to any one of claims 19 to 23, wherein before the first wafer and the structure thereon are scribed along the scribe lines, the fabrication method of a three-dimensional integrated circuit further comprises:
providing a plurality of fourth chips, and bonding the fourth chips to a surface, away from the first chips, of the first wiring layer, so that the fourth chips are coupled to the metal pattern in the first wiring layer, and an orthographic projection of the fourth chip on the first wafer is located within an orthographic projection of the first chip on the first wafer.

29. The fabrication method of a three-dimensional integrated circuit according to claim 28, wherein before the first wafer and the structure thereon are scribed along the scribe lines, the fabrication method of a three-dimensional integrated circuit further comprises:
forming at least one fourth through hole on at least one of the fourth chips;
forming a fourth conductor in the fourth through hole, so that one end of the fourth conductor is coupled to a fifth wiring layer in the fourth chip, and the other end of the fourth conductor is exposed; and
forming a sixth wiring layer on a surface, away from the first wiring layer, of the fourth chip, so that a metal pattern in the sixth wiring layer is coupled to the other end of the fourth conductor.

30. The fabrication method of a three-dimensional integrated circuit according to claim 28, wherein before the first wafer and the structure thereon are scribed along the scribe lines, the fabrication method of a three-dimensional integrated circuit further comprises:
aligning and bonding a second substrate to the first wiring layer bonded with the fourth chips, so that the fourth chip is accommodated in a third cavity on the second substrate;
forming a plurality of fifth through holes on the second substrate;
forming a fifth conductor in the fifth through hole, so that one end of the fifth conductor is coupled to the metal pattern in the first wiring layer, and the other end of the fifth conductor is exposed; and
forming a sixth wiring layer on a surface, away from the first wafer, of the second substrate, so that a metal pattern in the sixth wiring layer is coupled to the other end of the fifth conductor.

31. The fabrication method of a three-dimensional integrated circuit according to claim 29 or 30, wherein before the first wafer and the structure thereon are scribed along the scribe lines, the fabrication method of a three-dimensional integrated circuit further comprises:
forming at least one conductive micro-bump on a surface, away from the fourth chip, of the sixth wiring layer, so that the conductive micro-bump is coupled to the metal pattern in the sixth wiring layer.
